(19) **Europäisches Patentamt / European Patent Office / Office européen des brevets**

(11) **EP 1 476 828 B1**

(12) **EUROPEAN PATENT SPECIFICATION**

(45) Date of publication and mention
of the grant of the patent:
**24.10.2007 Bulletin 2007/43**

(51) Int Cl.:
**G06F 17/50** (2006.01)

(21) Application number: **02700539.6**

(86) International application number:
**PCT/IE2002/000023**

(22) Date of filing: **22.02.2002**

(87) International publication number:
**WO 2003/079237 (25.09.2003 Gazette 2003/39)**

(54) **A METHOD AND A PROCESSOR FOR PARALLEL PROCESSING OF LOGIC EVENT SIMULATION**

VERFAHREN UND PROZESSOR ZUR PARALLELEN VERARBEITUNG EINER LOGIKEREIGNIS-SIMULATION

PROCEDE ET PROCESSEUR POUR TRAITEMENT PARALLELE DE SIMULATION D'EVENEMENT LOGIQUE

(84) Designated Contracting States:
**AT BE CH CY DE DK ES FI FR GB GR IE IT LI LU MC NL PT SE TR**

(43) Date of publication of application:
**17.11.2004 Bulletin 2004/47**

(73) Proprietor: **NEOSERA SYSTEMS LIMITED**
**Belfield, Dublin 4 (IE)**

(72) Inventor: **DALTON, Damian**
**County Dublin (IE)**

(74) Representative: **Schütte, Gearoid**
**Cruickshank & Company**
**8A Sandyford Business Centre**
**Sandyford**
**Dublin 18 (IE)**

(56) References cited:
**WO-A-01/01298**

• **DALTON D: "The speedup performance of an associative memory based logic simulator" PARALLEL COMPUTING TECHNOLOGIES. 5TH INTERNATIONAL CONFERENCE, PACT-99. PROCEEDINGS (LECTURE NOTES IN COMPUTER SCIENCE VOL.1662), PARALLEL COMPUTING TECHNOLOGIES. 5TH INTERNATIONAL CONFERENCE, PACT-99. PROCEEDINGS, ST. PETERSBURG, RUSSIA, 6-10 SEPT. , pages 207-216, XP000980453 1999, Berlin, Germany, Springer-Verlag, Germany ISBN: 3-540-66363-0**

Printed by Jouve, 75001 PARIS (FR)

## Description

## Introduction

This invention relates to a processor for parallel processing of logic event simulation and a parallel processing method of logic event simulation on circuits comprising a plurality of logic gates, the logic gates having interconnect lines therebetween, the method being carried out in a main processor and an Associative Memory Mechanism, the Associative Memory Mechanism comprising a plurality of associative arrays and at least one result register.

One of the problems encountered in the field of parallel processing has been achieving significant speed up figures commensurate to the additional processing power available for simulation. There have been many different approaches to solving this problem including the use of compiled code and event driven simulation in which a circuit is partitioned amongst processors. In compiled code simulation all gates are evaluated at all time steps even if they are not active. The circuit has to be levellised and only unit or zero delay models can be employed. This compiled code mechanism has been applied to several generations of specialised parallel hardware accelerators designed by IBM as well as the Yorktown simulation engine and the engineering verification engine (EVE). Although impressive speed of figures for the methods have been reported, they are often misleading as gates that are not active or being evaluated as well and therefore the actual processing power is only a fraction of that reported.

Another approach taken is that described by Soule and Blank in : Parallel Logic Simulation on General Purpose Machines (Proc Design Automation Conf, June 1988, 166-171). However the intrinsic unit delay model of compiled code simulators is overly simplistic for many applications. Some delay model limitations of compiled code simulation have been eliminated in parallel event-driven techniques. These parallel algorithms are largely composed of two phases, a gate evaluation phase and an event-scheduling phase. The gate evaluation phase identifies gates that are changing and the scheduling phase puts the gates affected by these changes (the fan-out gates) into a time-ordered linked schedule list, determined by the current time and the delays of the active gates. However, overall performance has been disappointing and usually speed of figures ranging from 3 to 5 have been achieved.

Various optimising strategies such as load balancing, circuit partitioning and distributed queues are used to realise the best speedup figures. Unfortunately, these mechanisms themselves contribute large overhead communication costs for even modest sized parallel systems. This leads to a reduction in the speed of figures and a rather complex system. Furthermore, the gate evaluation process incurs between 10 and 250 machine cycles per gate evaluation, which is time consuming and costly to the processing capability of the machine.

All of these approaches claim to achieve more significant speed-up figures than was previously attainable. However, both of these approaches were still found to be insufficient to warrant the increase in the amount of additional processing power provided for the gain in speed-up times achieved.

This led to a parallel processing method of logic event simulation incorporating an associative memory mechanism as described in the Applicants own PCT Patent Application No. WO 01/01298. In WO 01/01298 the Applicant describes using a parallel processing method of logic event simulation with an associative memory mechanism in which the history of values on a particular line may be stored as a bit sequence and gate evaluations may be carried out on these bit sequences in both hardware and software resulting in superior speed up figures for parallel processing.

There were however a number of problems with the parallel processing method of logic event simulation using an associative memory mechanism. The main problem with the approach taken in WO 01/01298 was that the size of circuit to be evaluated was limited by the size of the associative memory mechanism associative arrays. Typically, this would limit the capacity of the associative arrays to a few thousand logic gates, which prevented practical large scale use of the invention. By simply increasing the size of the associative arrays the design became unwieldy and difficult to manage.

Conventional Cache Memory Mechanisms were heretofore unsuitable for use with such a method of parallel processing of logic event simulation. Conventional Cache Memory Mechanisms deal on a geographical based system, known as the principle of locality of reference and a probabilistic based system of data retrieval. Usually there is a probability as high as 90% or more that the correct memory block is brought in but this would not be acceptable in the associative memory mechanism provided. Such a system also wastes valuable processing time when a reference is made to a particular block that has not been brought in from external memory at the appropriate time. A more accurate Cache system was necessary for the parallel processing method of logic event simulation that was hereto fore available.

Another difficulty experienced by the Applicants was that the number of tests that could be carried out on gates pairs in the associative arrays was limited by the number of bits per word in the Group-Result Register Bank (GRRB). This prevented very extensive testing of a circuit being carried out in a single sequence and instead testing had to be carried out in a number of discrete stages. In addition to the above it was further discovered that valuable processing time was being taken up in the evaluation of the interconnect lines thereby putting further demands on the processing time of the parallel processor. Also, there was no way of modelling synchronous devices as they were too complex to manage in the known parallel processing method of logic event simulation.

All of these meant that although a significant advance had been made over the prior art in achieving speed up figures for the parallel processing method the device was still impractical for everyday application.

The object of the present invention is to provide a parallel processing method of logic event simulation and a processor to carry out the method that overcomes at least some of these difficulties and to provide an improved parallel processing method of logic event simulation.

### Statements of Invention:

According to the invention there is provided a parallel processing method of logic event simulation on circuits comprising a plurality of logic gates, the logic gates having interconnect lines therebetween, the method being carried out in a main processor and an associative memory mechanism, the associative memory mechanism comprising a plurality of associative arrays and at least one result register, characterised in that:-

there is provided an external memory and means to transfer data between the associative memory and the external memory, the method comprising the steps of:

storing a circuit representation in external memory;

dividing the circuit representation into a plurality of circuit segments;

assigning a unique segment identifier to each segment;

generating a circuit segment table in the associative memory and storing the unique segment identifiers along with segment data in a circuit segment table;

for each time period, identifying segments that may be active in that time period based on the segment data stored in the circuit segment table; and

bringing active segments into the associative memory mechanism from external memory for evaluation.

By storing the circuit representation in external memory and dividing the circuit up into a plurality of segments, the segments may be brought into the associative memory mechanism one at a time as required. In this way only potentially active segments need to be brought into the associative memory mechanism (AMM) during any one-time interval. This means that circuits of potentially any size may be evaluated using the method shown. In addition to this, by using the associative memory mechanism to store the circuit segment table, tests and evaluations on the circuit segment data may be carried out in a quick and efficient manner as well as utilizing all available storage space. Another advantage of using what could be described as a cache-like system is that unlike conventional cache memory mechanisms which are based on a probabilistic and geographical based system for determining memory block retrieval, the present method extracts segments from memory in the knowledge that these blocks are potentially active and must be evaluated in a particular time segment. This means that time is not wasted by the processor retrieving segments from memory only after it has been alarmed that a particular block was missing as there is certainty as to whether a block must be brought in from memory or not.

In another embodiment of the invention there is provided a parallel processing method of logic event simulation in which the segment data stored in the circuit segment table comprises the maximum delay state of a segment, which indicates the maximum time delay in which any gate in that segment may make a transition. By storing the maximum delay state of a segment the processor will be aware that a particular segment must be brought in for evaluation each time until the maximum delay state is in a state where no changes to gate outputs will occur or until there is a change to an input to that segment. This also prevents segments that are inactive from being brought in for evaluation each time unit and therefore optimizes the processing time of the processor.

In one embodiment there is provided a parallel processing method of logic event simulation in which the associative memory mechanism comprises a pair of associative arrays, associative array 1a and associative array 1b, an input value register bank and a hit list. This is seen as a simple and manageable layout for the associative memory mechanism.

In one embodiment of the invention there is provided a parallel processing method of logic event simulation in which the circuit segment table data of associative array 1a, associative array 1b and input value register bank are stored in external memory during segment evaluation. By storing the circuit segment table in external memory the total memory utilised may be optimised. In this way the full associative memory mechanism may be used for gate evaluations, as the segment table is stored externally while segments are being evaluated.

In one embodiment there is provided a parallel processing method of logic event simulation in which after evaluation of a segment the segment data of all its' fan-out gates are updated. When a segment is evaluated it may have fan out gates in a separate segment. These fan out gates may then affect the segment data in their own segments. A check is made to update each segment of a fan-out gate to ensure that the segment data is up to date. Previously inactive segments may become active and by updating the segment data of fan out gates the segment data remains correct.

In another embodiment of the invention there is provided a parallel processing method of logic event simulation in which when a new maximum delay state is greater than the previous maximum delay state of a fanout segment, the segment data is updated with the new maximum delay state. This ensures that a potentially active segment will be brought in for evaluation at all times. Updates to segment data is captured by the method.

In a further still embodiment of the invention there is provided a parallel processing method of logic event simulation in which inactive segments are not brought into the associative memory mechanism for evaluation until they have undergone an input change to a gate in that segment. This minimises the pressures on the processing time of the processor. Previous systems in other known architectures waste significant time and hence reduce the speed up figures by spending valuable processing time on evaluation of dormant gates. The method shown avoids this by only evaluating potentially active gates.

In a further embodiment of the invention there is provided a parallel processing method of logic event simulation in which all interconnect lines are held in a segment dedicated to interconnect lines. As interconnect lines are a passive entity and do not need to undergo evaluation, significant saving in processing time may be saved rather than constantly evaluating these interconnect lines.

In another embodiment of the invention there is provided a parallel processing method of logic event simulation in which all logic gates of a particular type are held in segments with logic gates of the same type. This is seen as beneficial as only tests pertinent to the gate type need be applied thus further speeding up the processing time taken by the method.

In one embodiment of the invention there is provided a parallel processing method of logic event simulation in which the segment table is an $N_s$ x M bits segment table where $N_s$ is equal to the number of segments and M is equal to the sum of the number of bits wide of associative array 1 a, associative array 1b, input value register and the hit list. The combined widths of array 1 a, array 1b, input value register and hit list are sufficient to store the segment table in a compact and manageable format. Sufficient space is provided to store all necessary information concerning each segment.

In one embodiment of the invention there is shown a parallel processing method of logic event simulation in which at least portion of associative array 1a, associative array 1b, input value register bank and the hit list are used to store the segment table at all times. This is seen as beneficial as the segment table will remain in the associative array at all times and time is not wasted in writing the data in the segment table to and retrieving the data from external memory. In another embodiment still of the invention there is provided a parallel processing method of logic event simulation in which when gate evaluations are completed for a particular time interval the previous segment table history is stored in the associative array 1b. By having the previous segment table stored here it is also accessible for further testing to be carried out on the segment data. Previous segment table may be easily compared with current segment table to ascertain changes in the individual segment's segment data and to provide analytical data.

In a further embodiment of the invention there is provided a parallel processing method of logic event simulation in which the input value register bank is shifted into associative array 1b, and associative array 1 a contains the maximum state of each segment, test patterns are then applied to contents of array 1b to determine transitions to lower states. The segment data of the current segment table may be compared with previous segment table data to check the transitions to lower states. This may mean that a state has transitioned to an inactive state where no evaluations are necessary or simply a lower state where further evaluations will have to be carried out.

In one embodiment of the invention there is shown a parallel processing method of logic event in which segments in the state $S_O$ are brought in for evaluation. Any segment reaching this state must be brought in for evaluation as it is the final state which any gate in a segment may change. This may then change to an inactive state such as $S_{TERM}$ once the evaluation has taken place.

In one embodiment of the invention there is shown a parallel processing method of logic event simulation in which the minimum state of all segments, $S_{STATEMIN}$, is calculated and all states are time advanced by $S_{STATEMIN}$ Time Units before evaluation of the segments commences. This is seen as particularly beneficial as if no states are actually undergoing any changes in that interval then all segments may be time advanced by the minimum delay state of all the segments. This effectively skips the simulation to the next point in time in which any gates may undergo change and therefore prevents time being wasted in waiting for the lowest segment state to decrease to state $S_O$. Significant savings to simulation time may be made using this method.

In a further embodiment of the invention there is provided a parallel processing method of logic event simulation in which the set up time, $T_{SETUP}$, of synchronous devices may be modelled where $T_{setup} = N.p + M$, where N = integer, M = integer < P and P = bit width of array 1 b, where by the following steps:-

the state entry of array 1a of this signal is set to $S_{sn}$ ;

a start marker is placed in the left most position of array 1b;

array 1b is incremented in time in the normal manner and when the start marker reaches the right-most position of array 1b and the signal has remained con-

stant, the state $S_{sn}$ is decremented to $S_{sn-1}$, and the next time array 1b is incremented the start marker is returned to the left-most position in array 1b once again and array 1b is then incremented in the normal manner;

the previous step is repeated until state entry $S_{sn}$ = $S_{so}$, then the array 1b is incremented another M times; and

if the signal has remained constant for N.p + M time units then the state entry in array 1a is set to state setup, $S_{SETUP}$.

By using this method, synchronous devices may be modeled using the processor with access to external memory. This allows for many more devices to be simulated accurately than was possible before. This is partially due to the provision of the associative memory mechanism, which allows for the modeling to be carried out in a simple and efficient manner.

In another embodiment still of the invention there is provided a parallel processing of logic event in which the hold time, $T_{HOLD}$, of synchronous devices may modeled where $T_{hold} = R.p + Q$, and where R = integer, Q = integer < P and P = bit width of array 1 b using the following steps:

when a clock makes a transition there is a search of state entries in array 1a to see if any input signals are in state $S_{setup}$;

states in $S_{setup}$ are updated to the state $S_{HR}$, and a start marker is placed in the left-most position of array 1b, array 1b is incremented in the normal manner and until the marker has made its way to the right-most position in array 1b and the signal has remained constant;

the state is decremented to $S_{HR-1}$, the start marker is returned to the left-most position in array 1b the next time that array 1b is

incremented, array 1b is then incremented in the normal manner and this is continued until the state is equal to $S_{Ho}$ ;

when $S_{HR} = S_{HO}$ then the array 1b is incremented a further Q times;

if signals remain constant over the entire period then the signal state is updated to $S_{HOLD}$ and the output value of the device is ascertained.

These synchronous devices may now be accurately modeled and included in any simulation of a circuit carried out. It is achieved in a simple and efficient manner with a minimum cost in processing time. The method will easily determine whether the hold time conditions of a synchronous device have been satisfied and whether those conditions were satisfied during a clock transition to cause a change in the output of the device.

In one embodiment of the invention there is provided a parallel processing method of logic event simulation in which if the output value of the device has changed it is propagated to the fan-out list of the device. This will again ensure that the processor remains up to date and any segment data of fan out gates will also be updated if necessary.

In one embodiment of the invention there is shown a parallel processing method of logic event simulation in which successive states are generated by causing a shift right operation in array 1a. A simple parallel shift right operation is simple to carry out and is not taking on processor time. Furthermore, it is a reliable way of transitioning through the successive states of a device.

In one embodiment of the invention there is shown a parallel processing method of logic event simulation in which there is provided an amended result registering mechanism in which when a number of tests are carried out on a gate pair the result of each test is sent to a result register where on completion of all the tests the result register will indicate that all tests were successful or that at least one was unsuccessful. This method will greatly increase the number of tests that may be carried out on a gate pair. Previously, this was limited to the number of bits in the group result register bank. Tests on bit sequences could then be carried out to see if all tests were successful. Now, all the individual running the simulation will know is whether or not all the tests were successful or whether at least one test was failed. This is particularly useful as hundreds of tests may now be carried out sequentially, allowing the more thorough testing to be applied and therefore ultimately greater reliability of the circuit being tested may be achieved.

In one embodiment of the invention there is provided a parallel processing method of logic event simulation in which the result register comprises an adder. This will allow the tester to check the total number of tests against the successful number of tests in a simple manner. It will be readily apparent if any tests have been failed. Alternatively, the result register may be a bi-state device, preferably the result register will be a D-flip-flop. By having either a bi-state device or a D-flip-flop, the previous results and the present result could be combined in the device whereby if both tests were successful the output of the register would give an appropriate signal that the tests were successful. However, if one test was unsuccessful this would be reflected by the output of the bi-state device or D-flip-flop that would indicate an unsuccessful test. The output of the bi-state device or D-flip-flop would remain indicating that a test had been failed until all the tests were completed. This allows the simulation to incorporate many more tests than was previously possible.

In another embodiment of the invention there is shown a parallel processing method of logic event simulation in which the result register on start-up is supplied with an appropriate priming input instead of last result so that it is ready to receive the first result. In some instances the result register may need to be primed with a priming input to ensure that if the first test is successful it is recorded as such.

In a further still embodiment of the invention there is provided a parallel processing method of logic event simulation in which the amended result registering mechanism further comprises a result polarity circuit to invert a result and ensure a logic 1 is applied to the result register if the correct response to a test was for the test to be failed. There may be particular tests carried out on gate pairs in which it will be desirable for the test to have been failed. This is, of course, in fact a successful test and should be recorded as such by the result register. By having a result polarity circuit it is possible to carry out tests that are to be either successful or failed, which allows further flexibility when carrying out testing.

In one embodiment of the invention there is provided a parallel processing method of logic event simulation in which the result polarity circuit comprises a pair of AND gates, a pair of inverters and an OR gate, a result polarity control is fed to each of the AND gates, the other input of each of the AND gates being provided by the result of a test carried out on a gate pair, the inverters inverting the two inputs to one of the AND gates, the outputs of the AND gates being fed directly to the OR gate. This is seen as a particularly simple structure that is both simple and efficient as well as being both space and cost efficient for the circuitry involved.

In another embodiment of the invention there is provided a parallel processing method of logic event simulation in which the amended result registering mechanism is further provided with a logic combination circuit to determine whether an output gate pair of array 1b are ANDed or ORed together. Again by having a logic combination circuit the type of test carried out on gate pairs can be achieved simply and quickly. The gate pairs may be toggled between an AND operation and an OR operation with a minimum of fuss.

In one embodiment of the invention there is provided a parallel processing method of logic event simulation in which the logic combination circuit further comprises three AND gates and a logic combination circuit control, the logic combination circuit control being ANDed individually with each output of an array 1b gate pair and the gate pair ANDed in the third AND gate, when the logic combination requires an AND operation to be carried out, logic combination circuit control is given a value 0 and if an OR operation is required logic combination circuit control is given a logic value 1. This is seen as a particularly useful implementation of the logic combination circuitry as it has very few gates and therefore will be both space and cost efficient as well as being inexpensive to provide. In addition to the above the logic combination circuit may include an OR gate, each of the outputs of the three AND gates being fed to the OR gate. This groups the three results in a simple and efficient manner and results in a single line being used for the onward transmission to further circuitry. In one embodiment the output of the OR gate is led to the result polarity circuit as the result of a test carried out on a gate pair.

In another of the invention there is provided a parallel processing method of logic event simulation in which there is provided an amended result registering mechanism for each gate pair. This will provide less delays in the circuitry and although further circuitry is necessary, in fact less circuitry than was necessary before having a result register for each gate pair was possible. In this way, the results of each gate pair can be checked individually.

In a preferred embodiment of the invention there is provided a parallel processing method of logic event simulation in which when all active segments have a state > S0, a check of all segment states is made until the lowest segment state $S_{MIN}$ is found, then each segment state is decremented by $S_{MIN}$ in order to advance simulation to the next evaluation state. This minimizes the time that the processor remains inactive by advancing the segment with the minimum state to the state at which it must be evaluated. This eliminates gate evaluation over time periods when there is no gate activity. This optimizes the processing speed up times further achieved by the method.

In another preferred embodiment of the invention there is provided a parallel processing method of logic event simulation in which the lowest state value is stored in a low global register and each time there is a gate state change if the new state is less than the low global state register value the low global register state value is replaced by the new state. This keeps a constant measure on the minimum state of all the segments so that the processor does not spend time evaluating gates during inactive time periods.

In another embodiment of the invention there is provided parallel a processing method of logic event simulation in which there is provided a scan system comprising a priority decoder and a shift register. This provides an efficient way of noting any results in the processor and is furthermore a cost efficient and satisfactory way of detecting these results.

In one embodiment of the invention there is provided a parallel processing method of logic event simulation as claimed in any preceding claim in which there is provided a segment address table and the segment address table is divided into a number of rows, each row being M bits long, and each segment address is stored in the most significant M - D bits of the segment row when the number of segments = $2^D$.

In another embodiment still of the invention there is provided a processor for parallel processing of logic event simulation on circuits comprising a plurality of logic gates, the logic gates having interconnect lines therebetween, the processor further comprising a main processor and an associative memory mechanism, the associative memory mechanism comprising a plurality of associative arrays and at least one result register, characterized in that: -

there is provided accessible external memory for storage of a circuit representation;

means to divide the circuit representation into a plurality of circuit segments;

means to allocate a circuit segment identifier to each circuit segment, each circuit segment identifier having circuit segment data associated therewith;

the associative memory mechanism comprising a segment table for storage of segment identifiers and segment data;

means to identify active segments in any one time interval based on the segment data; and

means to retrieve those active segments from external memory for evaluation by the associative memory mechanism.

By having a processor for parallel processing with an associative memory mechanism such as this the circuit may be divided into several different segments and each segment may be brought in to the associative memory mechanism for evaluation when required. Only potentially active segments need to be brought in at any time interval, this improves the speed of figures achieved by the processor. The processor will furthermore have less processing demands on it.

In one embodiment of the invention there is provided a processor in which the segment data further comprises the maximum time delay for a gate in that segment to undergo a transition. By having the maximum delay as part of the segment data the processor will be able to determine which segments must be brought in for evaluation and when they must be brought in from external memory.

In one of the invention there is provided a processor in which the Associative Memory Mechanism further comprises a pair of associative arrays (1a and 1b), an input value register and a hit list. This is seen as a particularly efficient structure for the associative memory mechanism.

In another embodiment of the invention there is provided a processor in which cache data of associative array 1a, associative array 1b and input value Register Bank are stored in external memory during evaluation. By storing this data in external memory during evaluation the Associative Memory Mechanism is freed up to carry out evaluations on the segments.

In a further embodiment of the invention there is provided a processor in which after evaluation of the segment data the segments fan-out lists are updated. By updating the fan out lists of a segment the segment data is kept up to date. Each segment undergoing a transition may affect the maximum delay time or other data of another segment and this is noted subsequent to each evaluation.

In a further still embodiment of the invention there is provided a processor in which all interconnect lines are held in a segment dedicated to interconnect lines. As interconnect lines are passive elements they do not require evaluation as they do not undergo transitions in the same way that logic gates do. Therefore, they do not have to be brought in to the processor for evaluation. By grouping all of the interconnect lines in the same segment the processor will not have to carry out evaluations on this segment and therefore the processor's actual processing time is optimised.

In another embodiment still of the invention there is provided a processor in which all Logic gates of a particular type are held in a segments with logic gates of the same type. This is seen as advantageous as similar tests may be carried out on gates of the same type in the one segment. This further increases the speed-up figures of the processor.

In one embodiment of the invention there is provided a processor in which the segment table is an $N_S$ x M bit segment table where $N_s$ is equal to the number of segments and M is equal to the sum of all the number of bits width of associative array 1a, associative array 1b, input value register and the hit list. The associative array 1a, associative array 1b, input value register and hit list have been found to be sufficient to hold the segment table in a compact and manageable form.

In one embodiment of the invention there is provided a processor in which the set up time, $T_{SETUP}$, of synchronous devices may be modeled and in which $T_{SETUP} = N.p + M$, where N is equal to an integer, M is equal to an integer < P, and P is equal to the bit width of array 1b, in which:

the state entry in array 1a of this signal is set to $S_{SN}$;

a start marker is placed in the left-most position of array 1b;

array 1b is incremented in the normal manner and when the start marker reaches the right-most position of array 1b and the signal has remained constant, the state $S_{SN}$ is decremented to $S_{SN-1}$, and the next time array 1b is incremented the start marker is returned to the left-most position in array 1b once again and the array 1b is then incremented in the normal manner;

the previous step is repeated until state entry = $S_{S0}$, then the array 1b is incremented another M times; and

if the signal has remained constant for N.p + M time units then the state entry in array 1a is set to state setup, $S_{SETUP}$.

This allows the processor to handle synchronous devices in a simple and efficient manner that was here-to-for thought impossible. Modeling of these devices now enables a wider range of circuits to be modeled.

In one embodiment of the invention there is provided a processor in which the hold time, $T_{HOLD}$, of synchronous devices may be modelled where $T_{HOLD}$ = R.p + Q, and where R is an integer, Q is an integer < P and P is equal to the bit width of array 1b, in which: -

when a clock makes a transition there is a search of state entries in array 1a to see if any input signals are in state $S_{SETUP}$;

states in $S_{SETUP}$ are updated to the state $S_{HR}$, and a start marker is placed in the left-most position of array 1b, array 1b is incremented in the normal manner until the start marker has made its way to the right-most position in array 1b and the input signal has remained constant;

the state is decremented to $S_{HR-1}$, and the next time array 1b is incremented start marker is returned to the left-most position in array 1b, array 1b is then incremented in the normal manner and this is continued until the state is equal to $S_{H0}$;

when $S_{HR}$ equals $S_{H0}$ then the array 1b is incremented a further Q times;

if signals remain constant over the entire period then the signal state is updated to $S_{HOLD}$ and the output value of the device is ascertained.

This will allow for synchronous devices to be modeled accurately further broadening the application of the processor. This processor can determine whether the conditions for transition have been met and whether the device has satisfied all the criteria for it to change in an efficient manner.

In one embodiment of the invention there is provided a processor in which if the output value has changed, it is propagated to the fan-out list of the device. This will keep the fan out gates of the synchronous device and the associated segments of the fan-out lists up to date with accurate information.

In another still embodiment of the invention there is provided a processor in which there is provided an amended result registering mechanism in which when a number of tests are carried out on the gate pair the result of each test is sent to a result register where on completion of all the test the result register output will indicate that all tests are successful or that at least one test was unsuccessful. By having an amended result registering mechanism an unlimited number of tests may be carried out on the gate pair being evaluated. Before now, this number was limited which meant that the reliability of the device could only be guaranteed by a certain amount as a limited number of evaluations on each gate pair could be carried out sequentially. Now, a much more thorough testing processor is provided.

In one embodiment of the invention there is provided a processor in which the result register comprises an adder. Alternatively, it may be provided by a processor in which the result register is a bi-state device or a processor in which the result register comprises a D-flip flop. Any of these devices will indicate whether or not all of the tests were successful or not which is sufficient for the testers needs. Additionally, the adder may be used to determine how many of the tests were unsuccessful.

In another embodiment of the invention there is provided a processor in which the result register on start-up is supplied with an appropriate priming input instead of last result so that it is ready to receive the first actual result. It may be necessary on start up to provide a priming input, particularly in the case of the D-flip-flop to ensure the correct result is output from the device in the event that the first test is successful.

In a further embodiment of the invention there is provided a processor in which the amended result registering mechanism further comprises a result polarity circuit to invert a result and ensure logic 1 is applied to the result register if the correct response to a test was that a particular test on a gate pair was to be failed. In certain circumstances it may be required that a particular test on a gate pair is actually failed. This though, is in fact, the desired result and therefore a successful test. It is therefore necessary to invert the result of the gate pair test before it is applied to the result register. This is achieved by using the result polarity circuit.

In a further embodiment of the invention there is shown a processor in which the amended result register mechanism is further provided with a logic combination circuit to determine whether an output gate pair of array 1b are ANDed or ORed together. This is beneficial as different tests may be applied to the gate pairs as required by the individual determining which tests must be carried out. The person carrying out the test may chose to carry out AND or OR operations.

In one embodiment of the invention there is provided a processor in which logic combination circuit further comprises three AND gates and a logic combination circuit control, the logic circuit control being ANDed individually with each output of array 1b gate pair, and the gate pair ANDed in the third AND gate, when the logic combination requires an AND operation, logic combination circuit control is given a value 0 and when an OR operation is required logic combination circuit control is given a logic 1. This is a particularly simple implementation of the logic combination circuit and uses a very small number of gates to achieve its purpose.

In another embodiment of the invention there is provided a processor in which the logic combination circuit further comprises an OR gate, each of the outputs of the three and gates being fed to the OR gate. This is a convenient way of grouping each of the outputs for onward transmission to additional circuitry. Furthermore it is a simple and space efficient way of carrying out the invention.

In one embodiment of the invention there is provided a processor in which the output of the OR gate is led to the result polarity circuit. In this way the result of tests carried out on gate pairs may be inverted if required. The result is then ready for onward transmission to the result register.

In one embodiment of the invention there is provided a processor in which when all active segments have a state > S0, a check of all segment states is made until the lowest segment state $S_{min}$ is found, then each segment state is decremented by $S_{min}$ in order to advance simulation to the next evaluation stage. By incorporating this feature the processor will not have to be evaluated over time periods of inactivity for a lengthy period of time and the speed of the processing will be enhanced further.

In another embodiment of the invention there is shown a processor in which the lowest state value is stored on a low global register and each time there is a gate state change if the new state is less than the low global state register value it replaces the low global state register value. In this way the processor is kept up to date and a constant monitoring of the minimum segment state is carried out to minimize time wastage.

In a further embodiment of the invention there is provided a processor in which there is provided a scan system comprising a priority decoder and a shift register. This scan system will the processor to detect whether any 'hits' have occurred in a quick and simple manner. This will further increase the speed of the processor.

In another embodiment of the invention there is provided a processor in which there is provided an amended result registering mechanism for each gate pair. This will obviate queuing delays in the processor and even though a circuit is required for each gate pair even less components are required now than were needed before.

In a further embodiment of the invention there is provided a processor in which there is provided a segment address table, the segment address table is divided into a number of rows, each row being M bits long, and each segment address is stored in the most significant M-D bits of the segment row when the number of segments is equal to $2^D$. This is a simple and efficient way of addressing the segments in a uniform manner.

In one embodiment of the invention there is provided a processor in which the processor is embodied in computer readable format. Of course, the actual design of the processor may be in computer readable format such as compiled code or assembled code. Indeed it will often be much easier to run simulations on the processor in this form. When the processor is in this computer readable format it may be stored on a record medium such as a disc or a CD-ROM, DVD or any other similar record medium. Indeed the computer readable format may be stored on a carrier wave signal such as a radio wave of other such transmissible wave. The computer readable format may be transmitted over the Internet by such means. Indeed, when the carrier wave is being transmitted it may be by way of an optical carrier in which case the fibre-optic cables could be considered to be the carrier.

## Detailed Description of the Invention.

The invention will now be more clearly understood from the following description of some embodiments thereof given by way of example only with reference to the accompanying drawings in which:-

Fig. 1 is a block diagram of a processor for parallel processing of logic event simulation;

Fig. 2 is a block diagram of the segment table;

Fig. 3 illustrates a pair of logic gates, one of which being the fan-out gate of the other;

Fig. 4 illustrates the incorporation of segment addresses in fan-out addresses;

Fig. 5 is a logic gate representation of the result polarity circuit;

Fig. 6 is a logic gate representation of the logic combination circuit;

Fig. 7 is a logic gate representation of the amended result registering mechanism;

Fig. 8 is a timing diagram showing the set-up and hold times of a synchronous device;

Fig. 9 is a block diagram of a gate input addressing technique; and

Fig. 10 is a block diagram of a scan system for use in the processor for parallel processing of logic event simulation.

Before describing the invention in detail it is thought useful to have a brief description of parallel processing of logic event simulation incorporating an associative memory mechanism. In using this technique, the processing of the logic simulation may be carried out faster than in other known topographies by hard-wiring many of the calculation steps carried out by the processor. Signals on a line are represented as a bit sequence in logic. In its simplest form i.e. using two-state logic where a single bit is used to represent the signal on a line, a line will either have the binary value 1 or 0. 1 for high and 0 for low. Obviously two, three or even more bits may be used to represent the signal value on a line.

These signal values may then be stored in the associative memory mechanism in word form in, for instance, associative array 1b. If two-state logic is being used and associative array 1b is 32 bits wide, then the current value of the signal on the line as well as the previous 31 values of the signal on that particular line may be stored in array 1b. Tests may then be carried out on these bit sequences to determine whether a particular gate went through a transition or not. Checks may be made to see if all tests that were carried out were successful or whether or not a test was failed whilst processing a particular circuit.

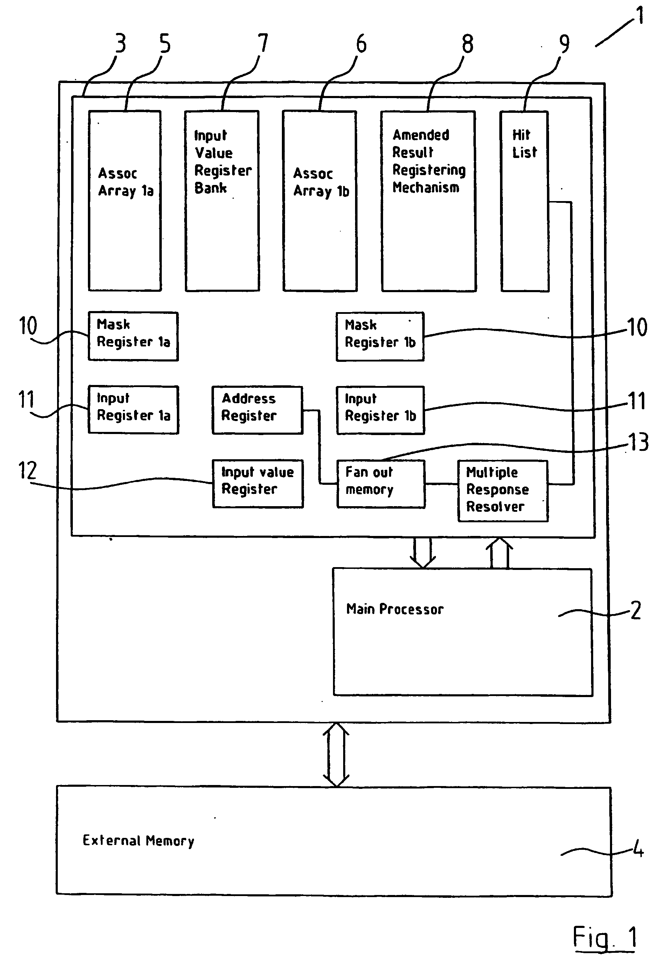

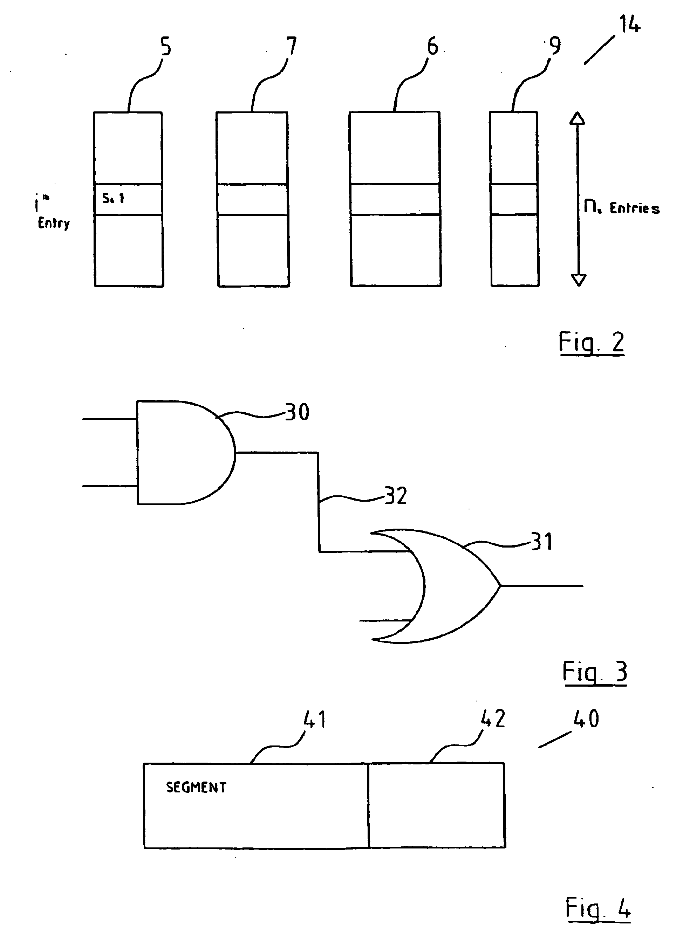

Referring now to the drawings and initially to Figs. 1 and 2 thereof there is shown a processor for parallel processing of logic event simulation indicated generally by the reference numeral 1, comprising a main processor 2 and an associative memory mechanism 3. There is further provided accessible memory 4 for access by the main processor 2 and associative memory mechanism 3.

The associative memory mechanism 3 further comprises a pair of associative arrays, associative array 1a, 5, and associative array 1b, 6, an input value register bank 7, amended result registering mechanism 8 and a hit list 9. Each of the associative arrays 5, 6, is provided with a mask register 10 and input register 11. Input value register bank 7 is also provided with an input value register 12. There is additionally provided a fan-out memory 13 to monitor updates to fan-out gates (not shown).

Means to divide a circuit representation (not shown) are provided to divide the circuit representation into a plurality of circuit segments and there are means to allocate a circuit segment identifier (not shown) to each circuit segment. Each circuit segment identifier has circuit segment data associated therewith. The associative memory mechanism 3 comprises a segment table 14 for storage of segment identifiers and segment data and means to identify active segments (not shown) based on the segment data and means to retrieve those active segments (not shown) from external memory for evaluation.

In use, a circuit representation is stored in external memory 4. This circuit representation is divided up into a number of circuit segments, each circuit segment is given a circuit segment identifier with circuit segment data associated therewith. The circuit segment data is stored in the segment table 14 and in any one time interval a check of the segment table is carried out to determine whether any segments are active in that time period. These active segments are brought in from external memory for evaluation in the associative memory mechanism 3. Any segment not in state $S_{TERM}$ or $S_{HOLD}$ is a potentially active segment and is brought in for evaluation by the associative memory mechanism. Once a segment has been evaluated the segment data and segment data of any fan-out gates of the gates in the original segment are updated accordingly.

Referring now specifically to Fig. 2, it can be seen from the drawing that the segment table 14 is stored in the associative array 1a, 5, associative array 1b, 6, input value register bank 7 and hit list 9. In total there may be N entries in the segment table. The maximum state, $S_{MAX}$, which represents the maximum time delay of any gate in that segment is stored as part of the segment data in associative array 1a, 5. This determines whether or not a segment will be potentially active and whether it should be brought into the associative memory mechanism 3 from external memory 4. The max state may be updated each time the particular segment is brought in for evaluation or each time a fan-out gate in that segment has a current state greater than the maximum state.

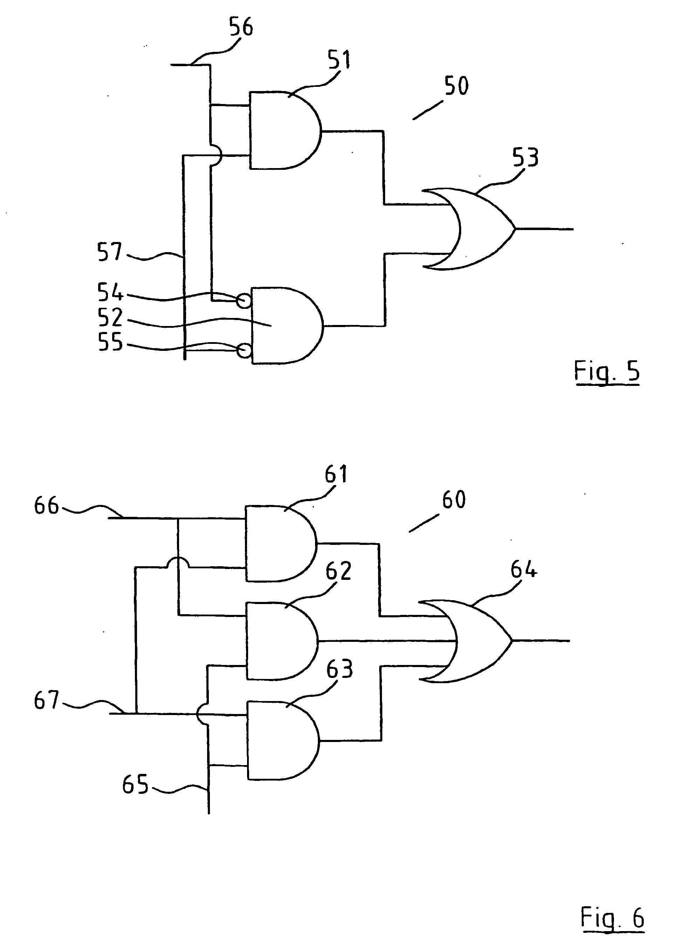

Referring now to Figs. 3 and 4 of the drawings, there is shown a typical scenario encountered in the processor for parallel processing of logic event simulation in which when a gate in a segment undergoes a transition, this transition must be propagated to the fan-out gates of that gate. These fan-out gates may be in another segment in which case the fan-out gates segment data may have to be updated accordingly. In Fig. 3 an AND gate 30 in one segment undergoes a transition in the current time interval. This AND gate is connected to its fan-out gate, in this case OR gate 31 by interconnect line 32. The fan-out address 40 (as shown in Fig. 4) of the OR gate 31 is divided into two parts, a segment address part 41 and a gate address part 42. The segment address part 41 contains the address of the particular segment in which the fan-out gate 31 is located and the gate address part identifies the actual fan-out gate 31 itself. The state value of the new signal propagated along the interconnect line 32 is determined and is compared with the maximum state of the identified segment. If the state value of the new signal is greater than the max state of the segment then the max state of the segment is updated accordingly.

Referring now to Fig. 5 of the drawings there is shown a result polarity circuit 50, for the amended result registering mechanism 8. It may in some instances be desirable to have tests on a gate pair that are failed. In these instances the result actually represents a successful test. Therefore, depending on the result register (not shown) being used it may be necessary to represent successful tests with a logic 1 at all times. This is achieved by providing a result polarity circuit 50 that may invert the results of that test carried out on a gate pair in order to correctly indicate whether or not the test was successful.

The result polarity circuit comprises a pair of AND gates 51 and 52, an OR gate 53 and a pair of inverters 54 and 55. The result of a test from a gate pair is led along interconnect line 56 to AND gates 51 and 52. This result is passed through inverter 54 before reaching the input of AND gate 52. A result polarity control line 57 is in turn fed as input to each of the AND gates 51 and 52 respectively. The result polarity control line 57 is inverted before entering the AND gate 52. The outputs of the AND gates 51, 52 are fed directly to the OR gate 53 and from there onwards to the result register.

In use, if a test on a gate pair was to be successful, result polarity control line 57 is set to a logic value 1. If the test was successful then the output of AND gate 51 would also be a logic '1' which would in turn be passed to OR gate 53 and onwards to the result register. If however, the test was unsuccessful the value of interconnect line 56 would be an O and both AND gates 51 and 52 would output logic 0, which would indicate to the OR gate and afterwards to the result register that a test had been failed.

If it is desirable that a test on a gate pair was to be failed then the result polarity control line is set to logic value 0. In this way, if the result of the test on a gate pair was failed a logic 0 would appear on interconnect line 56. The output of AND gate 51 would also therefore be a O, however, the inputs to AND gate 52 are both inverted before entering AND gate 52. Therefore, the output of AND gate 52 would be a logic 1. This would be propagated to OR gate 53 and onwards to the result register that the test was successful. It can be seen that if the desired result to the test was for it to be failed and it was in fact passed, giving a logic 1 on interconnect line 56, as the result polarity control line 57 was at logic "0" both of the AND gates 51 and 52 would output a 0, thereby indicating that the test was unsuccessful.

Referring now to Fig. 6 of the drawings there is shown a logic combination circuit 60. The logic combination circuit 60 comprises three AND gates 61, 62 and 63 respectively and an OR gate 64 fed from each of the outputs of AND gates 61, 62 and 63. There is additionally provided a logic combination circuit control 65.

Output 66 and 67 of a gate pair are led to AND gate 61. Output 66 is also led to AND gate 62 and output 67 is also led directly to AND gate 63. The logic circuit combination circuit control 65 is fed as a second input to both AND gates 62 and 63. In certain circumstances, a test to be carried out on the outputs 66, 67 of a gate pair may comprise an AND operation. In other circumstances the test to be carried out on the outputs 66, 67 may be an OR operation. If the test to be carried out comprises an AND operation then logic combination circuit control 65, is set to logic value 0. Therefore, regardless of the values of outputs 66 and 67, the output of AND gates 62 and 63 will be zero. If both outputs 66 and 67 are a logic 1 then these are combined in AND gate 61 and the output of AND gate 61 and hence OR gate 64 will be a logic 1. If one of the output 66, 67 is a logic 0 then the output of AND gate 61 will also be zero and this is propagated to OR gate 64 indicating that the test was failed and the output of OR gate 64 is zero.

If the test requires an OR operation to be carried out on outputs 66, 67 then the logic combination circuit control 65 is set to a logic value 1. Therefore if either output 66 or output 67 is a logic 1 then the output of AND gates 62 or 63 respectively will be a logic 1. Alternatively if both outputs 66 and 67 are logic 1 then the output of logic gate 64 is also a logic 1. Only if both outputs 66 and 67 are a logic 0 then AND gates 61, 62 and 63 will all register a logic 0 at their outputs and the output of gate 64 is zero.

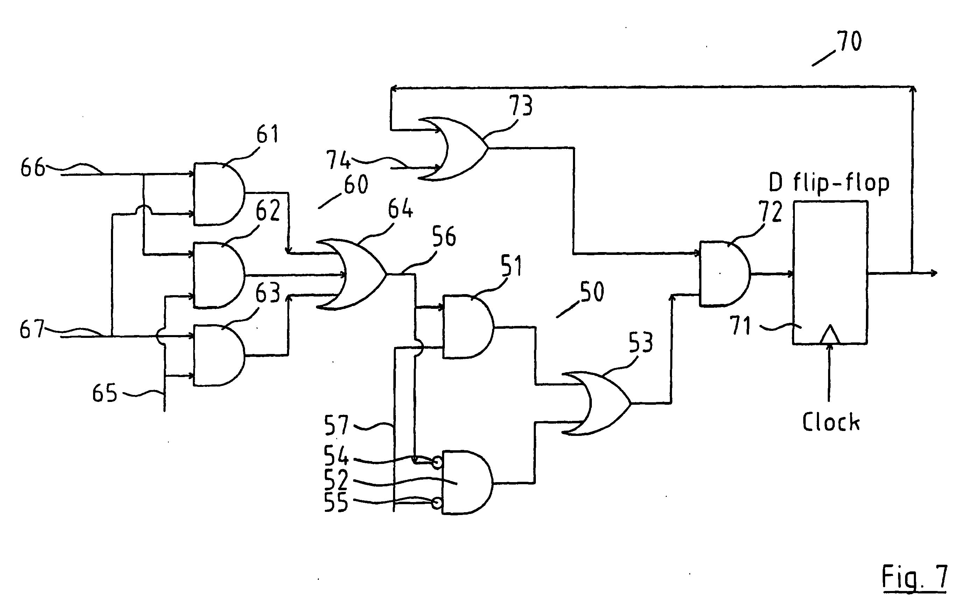

Referring now to Fig. 7 of the drawings, where like parts have been given the same reference numerals as before, there is shown an amended result registering mechanism, indicated generally by the reference numeral 70. The amended result registering mechanism further comprises a logic combination circuit 60, a result polarity circuit 50 and a result register provided by D-flip-flop 71. The input of D-flip-flop 71 is provided by the output of the result polarity circuit logically ANDed with the last output of the D-flip-flop 71 in AND gate 72. In other words, the input of the D-flip-flop comprises the result of the current test on outputs 66, 67 of a gate pair logically ANDed with the result of the last test on outputs 66, 67 of the gate pair. On start up, the output of the D-flip-flop will be 0 so a priming input is applied to OR gate 73 on input priming line 74. The other input to OR gate 73 is from result of D-flip-flop i.e. last result. On start up, the input priming line 74 is set to a logic value 1 giving OR gate 73 an output of logic 1, which is supplied to AND gate 72 where it is combined with the result of the first test on the gate pair outputs. If the test on the gate pair was successful then a logic 1 will be supplied to the AND gate 72 from result polarity circuit 50 thereby giving AND gate an output of logic 1, which is given to the D-flip-flop as the result of the test. The input priming line is then set to zero thereafter. If at any stage a test on the gate pair outputs 66, 67 is failed then the output of the AND gate will go to 0 and that result will be supplied to the D-flip-flop, which will in turn have a result 0. Due to the fact that previous result is ANDed with present result, the output of the D-flip-flop will remain at 0 thereafter and cannot change to logic 1 unless a new set of tests were started and input priming line was set to logic 1. Therefore, the individual testing the device will be able to see if any of the tests were failed as output of D-flip-flop will be logic 0 or if all the tests had been passed in which case output of D-flip-flop would equal 1. Theoretically, it is possible to apply an infinite number of tests to the outputs of a gate pair and see if all tests were successful or whether any were unsuccessful. It is envisaged that there will be an amended result registering mechanism for each gate output pair.

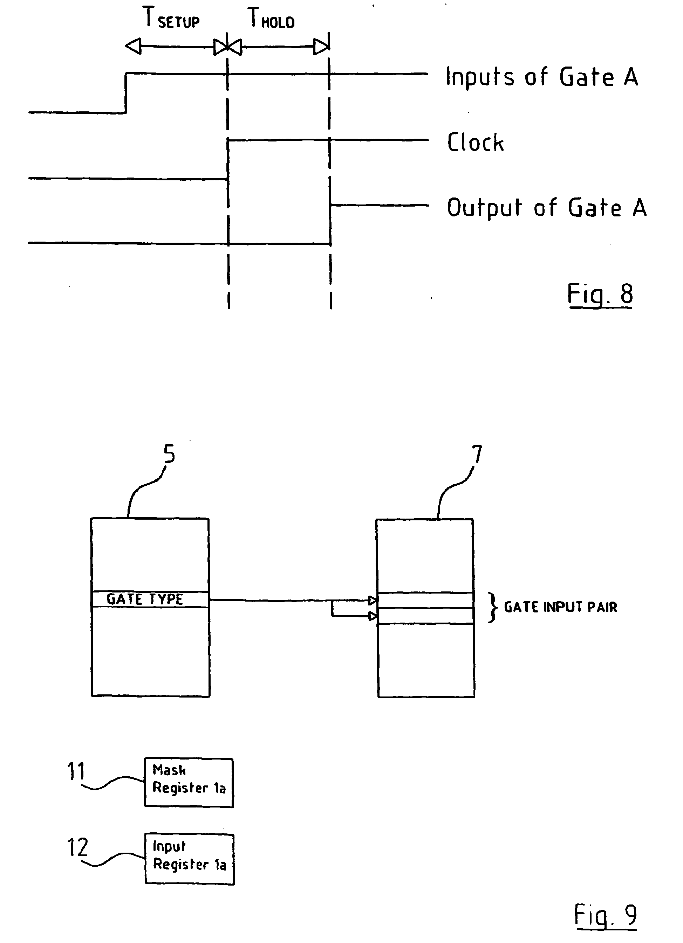

Referring now to Fig. 8 of the drawings there is illustrated the set up and hold timing diagram for a synchronous device. These devices include D-flip-flops, S-R flip-flops, J-K flip-flops and the like. These devices are triggered by the rising or falling edge of a clock signal. When triggered the output response of these devices is dependent upon the signal values on the inputs of these devices and in the case of the S-R Flip-Flop and the J-K Flip-Flop sometimes the output state of the device prior to the rising or falling edge determines the output response of the device after it is triggered. For edge triggered devices the output is only determinable if the input signals remain stable for a predefined time period before and after the active clock edge. These are defined as the Set-up and Hold times of the device.

In the processor the observance of these constraints can be validated. If we assume that each signal has a given Set-up and Hold time and that the length of the Set-up time is $T_{set-up}$. Furthermore, assume that the time represented by the width of Array 1b is p and the length of $T_{set-Up}$ is :

$$T_{set-up} = Np + M.$$

Where N = Integer, M = Integer < p.

Assume the length of the Hold time is $T_{hold}$. Furthermore, assume that the time represented by the width of Array 1b is p and the length of $T_{hold}$ is:

$$T_{hold} = Rp + Q.$$

Where R = Integer, Q = Integer < p.

The verification process that the input signal is held constant for a time period at least as long as $T_{set-up}$ can be implemented by initializing the State entry in Array 1a for this signal to state $S_{SN}$ when a transition on this wire is detected. Simultaneously, a start marker is positioned into the leftmost location of the corresponding word in Array 1b. Array 1b is updated in the normal manner. When the start marker reaches the right-most position in Array 1b and the logic value of the signal has remained constant for all time units contained within Array 1b, the State of the signal in Array 1b is updated to state $S_{SN-1}$. This condition can be determined by applying the appropriate test pattern search to Array 1a and Array 1b.

This state amendment process is repeated until state $S_{SO}$ is attained. When in state $S_{SO}$ tests are made on Array 1b in the normal time incrementation process to determine when the input signal is stable for a further M time units. When this condition is fulfilled the signal is updated to $S_{set-Up}$. This state indicates that the Set-up conditions on the signal have been obeyed and the signal remains in this state until either the signal or the controlling clock makes an active transition. If the signal makes a transition the signal is put into state $S_{SN}$ and the set-up validation procedure is repeated. However, if the clock makes a transition the signal enters the Hold validation process.

When the clock makes an active transition all input signals in state $S_{set-up}$ of a particular device type are identified in Array 1a through the parallel search mechanism of this array. These are put into state $S_{HR}$. Simultaneously, a start marker is positioned into the leftmost location of the corresponding word in Array 1b. Array 1b is updated in the normal manner. When the start marker reaches the right-most position in Array 1b and the logic value of the signal has remained constant for all time units contained within Array 1b, the state of the signal in Array 1b is updated to state $S_{HR-1}$. This condition can be determined by the applying the appropriate test pattern search to Array 1a and array 1b.

This state amendment process is repeated until state $S_{HO}$ is attained. When in state $S_{HO}$ tests are made on Array 1b in the normal time incrementation process to determine when the input signal is stable for a further Q time units. When this condition is fulfilled the signal is updated to $S_{hold}$ This state indicates that the Hold and Set-up conditions on the signal have been obeyed. If at any stage in the Hold validation process the signal makes a transition, the signal state reverts to State $S_{SN}$. Simultaneously as the signal state is updated to $S_{Hold}$ the input signal values of the device are determined by appropriate tests to Array 1b in order to ascertain the output value of the device. If the output value has changed it is propagated to the fan-out list of the device.

The $S_{Hold}$ state also indicates that the device has been evaluated and the fan-out updated. Successive states in these validation processes are generated through a shift right operation on the state binary representation. This is highly efficient as this can be accomplished in parallel in Array 1a on all relevant devices. States also have an encoding indicating the output value of the device prior to the current signal or clock transition.

When viewing the diagram shown in Fig. 8, it can be seen that the output of gate A will change once the set-up and Hold conditions have been satisfied for the device and the device has undergone a clock transition.

Referring now to Fig. 9 of the drawings there is shown a different way of addressing a gate pair in the input value register bank 7. Previously, two words in Associative Array 1a, 5, were used to address two input gate pair in the input value register bank. Now, for a gate input pair in which the logic gate being represented has equivalent inputs e.g. AND, OR, NAND or NOR gates, a single word in Array 1a, 5, may be used to activate two words in input value register bank 7.

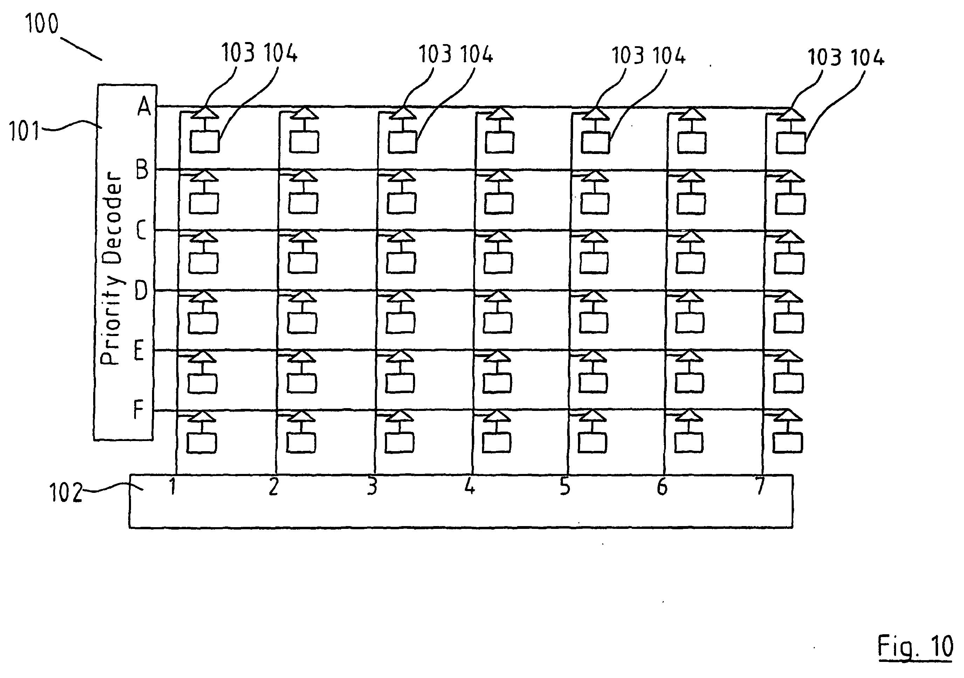

Finally, Fig. 10 of the drawings is a block diagram of a scan system for use in the processor for parallel processing of logic event simulation. The scan system indicated generally by the reference numeral 100 is particularly useful in the processor having access to external memory as hits will be able to be detected in a much quicker and more efficient manner. This is of great benefit as the number of hits will increase proportionately with the size of the circuit being simulated. The scan system 100 further comprises a priority decoder 101, a shift register 102 and a plurality of tri-state buffers 103 and hit registers 104.

In use, in order to resolve hits in the hit registers 104 the shift register 102 first sets column 1 high. This enables tri-state buffers 103 in column 1. The hit status of column 1 is then visible to the priority decoder 101 through lines A to F. The priority decoder 101 searches for highs on these lines. It starts searching at A, and it has the ability to skip any non-high lines and is able to find successive hits in one clock cycle. When the search of lines A - F is finished column 1 is set low and column 2 of the shift register 102 is set high. The priority decoder 101 is then able to search through lines A to F in column 2. This is repeated until all columns have been searched. The address of a hit may be determined by the position of the high bit in the shift register and the position of the high bit in the priority decoder. At present, a 24 bit shift register with a 64 bit priority decoder has been found to be adequate as this allows 1,536 hit registers to be scanned.

Another important aspect of the invention is the ability of the processor to advance time in the simulation. At certain times during the simulation it may occur that there will be no activity in the processor. During these times the processor is not carrying out calculations and is effectively dormant until there is either some gate or device activity. By having the circuit divided into a number of segments the individual states of each of the segments may be monitored. The minimum state of all the segments, $S_{MIN}$ may be stored in a dedicated register, low global register, if desired. When the processor is going through a simulation period of no activity there is provided means to advance all segments by $S_{MIN}$ states so that at least one segment is advanced in time to a state in which it must be evaluated by the processor. This ensures that the processor remains active for a greater percentage of time thereby enhancing the speed up figures of the processor. For instance, if we say that there are four segments in a circuit and the minimum state for each segment is as follows:

Segment 1, State-set = {S6}

Segment 2, State-set = {S4}

Segment 3, State-set = {S9}

Segment 4, State-set = {S6}

Segments are evaluated in state S0 and additionally in some cases fulfill a test pattern requirement on Array 1b. There will be no fan-out changes for any of the segments until the lowest state enters state S0. If we look at the set of states for each segment we can see that the lowest state initially is state S4. Therefore, all states must be decremented by S4 in order to bring this minimum state down to S0 and therefore bring the segment in for evaluation. Once each of the states has been decremented by S4 and segment 2 has been evaluated, the lowest remaining state is S2 in segments 1 and 3 respectively. All segments that are still potentially active are then decremented by S2, and segments 1 and 3 are, in turn, taken into the processor for evaluation. Once this has been achieved the remaining segment not in state S0 is segment 3. This is finally decremented by S3 and evaluated by the processor. Signal values in associative array 1b, 6, must also be adjusted to represent their amended values over this time period. This may be achieved by shifting the input value of each signal into all time positions of the corresponding word of associative array 1b. In this way, the processor having a number of segments, each segment having a plurality of logic gates and devices therein may have its potentially active segments time advanced to the next time in which a segment must be evaluated in order to avoid time wastage by the processor. Care must be taken not to confuse this with the maximum state being greater than S0. When the maximum state in a segment is greater than S0 it will still have to be brought in for processing in the associative memory mechanism. Of course, it will be understood that the segments may contain the maximum number of gates that may be held in the associative memory mechanism. Alternatively, it may be advantageous to have less gates in particularly active segments, for instance half the total possible number of gates. Alternatively, it may be advantageous to group the segments so that gates that are active for similar amounts of time are grouped together. It is seen as preferable to group interconnect lines into at least one segment on their own as they require no processing as they do not undergo evaluation and therefore need not take up valuable processing time.

In the example given the result register is shown as a D-flip-flop. Alternatively, this could be replaced an Adder in which the Adder could be incremented each time a test was successful and once all the tests have been completed the total of the Adder could be compared with the total number of tests carried out. In this way, the individual running the simulation would know whether all the tests have been successful or not. Alternatively, another bi-state device such as an AND gate could be used in isolation. The D-flip-flop is seen as preferable.

In some cases it may be desirable to keep the segment table in the associative memory mechanism at all times. This may increase processing requirements but will result in a faster processing system. This will result in the need for a larger associative memory mechanism but will obviate the need for time-consuming writes to and from external memory.

## Claims

1. A parallel processing method of logic event simulation on circuits comprising a plurality of logic gates, the logic gates having interconnect lines therebetween, the method being carried out in a main processor and an associative memory mechanism, the associative memory mechanism comprising a plurality of associative arrays and at least one result register, wherein
there is provided an external memory and means to transfer data between the associative memory and the external memory, the method comprising the step of:

    storing a circuit representation in external memory;
    **characterized by** further comprising the steps of:

        dividing the circuit representation into a plurality of circuit segments;
        assigning a unique segment identifier to each segment;
        generating a circuit segment table in the associative memory and storing the unique segment identifiers along with segment data in a circuit segment table;
        for each time period, identifying segments that may be active in that time period based on the segment data stored in the circuit segment table; and
        bringing active segments into the associative memory mechanism from external memory for evaluation.

2. A parallel processing method of logic event simulation as claimed in claim 1 in which the segment data stored in the circuit segment table comprises the maximum delay state of a segment, which indicates the maximum time delay in which any gate in that segment may make a transition.

3. A parallel processing method of logic event simulation as claimed in claim 1 and 2 in which the associative memory mechanism comprises a pair of associative arrays, associative array 1a and associative array 1b, an input value register bank and a hit list.

4. A parallel processing method of logic event simulation as claimed in claim 3. in which the circuit segment table data of associative array 1a, and associative array 1b and input value register bank are stored in external memory during segment evaluation.

5. A parallel processing method of logic event simulation as claimed in any preceding claim in which after evaluation of a segment the segment data of all its' fan-out gates are updated.

6. A parallel processing method of logic event simulation as claimed in claim 5 in which when a new maximum delay state is greater than the previous maximum delay state of a fan-out segment, the segment data is updated with the new maximum delay state.

7. A parallel processing method of logic event simulation as claimed in any preceding claim in which inactive segments are not brought into the associative memory mechanism for evaluation until they have undergone an input change to a gate in that segment.

8. A parallel processing method of logic event simulation as claimed in any preceding claim in which all interconnect lines are held in a segment dedicated to interconnect lines.

9. A parallel processing method of logic event simulation as claimed in any preceding claim in which all logic gates of a particular type are held in segments with logic gates of the same type.

10. A parallel processing method of logic event simulation as claimed in any of claims 3 to 9 in which the segment table is an $N_s$ x M bits segment table where $N_s$ is equal to the number of segments and M is equal to the sum of the number of bits wide of associative array 1a, associative array 1b, input value register and the hit list.

11. A parallel processing method of logic event simulation as claimed in any of claims 5 to 10 in which at least portion of associative array 1a, associative array 1b, input value register bank and the hit list are used to store the segment table at all times.

12. A parallel processing method of logic event simulation as claimed in any of claims 3 to 11 in which when gate evaluations are completed for a particular time interval the previous segment table history is stored in the associative array 1b.

13. A parallel processing method of logic event simulation as claimed in any of claims 3 to 12 in which the input value register bank is shifted into associative array 1b, and associative array 1a contains the maximum state of each segment, test patterns are then applied to contents of array 1b to determine transitions to lower states.

14. A parallel processing method of logic event simulation as claimed in any preceding claim in which segments in the state $S_O$ are brought in for evaluation.

15. A parallel processing method of logic event simulation as claimed in any preceding claim in which the minimum state of all segments, $S_{STATEMIN}$, is calculated and all states are time advanced by $S_{STATEMIN}$ Time Units before evaluation of the segments commences.

16. A parallel processing method of logic event simulation as claimed in any of claims 3 to 15 in which the set up time, $T_{SETUP}$, of synchronous devices may be modelled where $T_{setup} = N.p + M$, where N = integer, M = integer < P and P = bit width of array 1b, where by the following steps:-

the state entry of array 1a of this signal is set to $S_{sn}$ ;

a start marker is placed in the left most position of array 1b;

array 1b is incremented in time in the normal manner and when start marker reaches the right-most position of array 1b and the signal has remained constant the state $S_{sn}$ is decremented to $S_{sn-1}$, and the next time array 1b is incremented the start marker is returned to the left-most position in array 1b once again and array 1b is then incremented in the normal manner;

the previous step is repeated until state entry $S_{sn} = S_{so}$, then the array 1b is incremented another M times; and

if the signal has remained constant for N.p + M time units then the state entry in array 1a is set to state setup, $S_{SETUP}$.

17. A parallel processing method of logic event simulation as claimed in any of claims 3 to 16 in which the hold time, $T_{HOLD}$, of synchronous devices may modelled where $T_{hold} = R.p + Q$, and where R = integer, Q = integer < P and P = bit width of array 1b using the following steps:

when a clock makes a transition there is a search of state entries in array 1a to see if any input signals are in state $S_{setup}$;

states in $S_{setup}$ are updated to the state $S_{HR}$, and a start marker is placed in the left-most position of array 1b, array 1b is incremented in the normal manner and until the marker has made its way to the right-most position in array 1b and the signal has remained constant;

the state is decremented to $S_{HR-1}$, the start marker is returned to the left-most position in array 1b the next time that array 1b is incremented, array 1b is then incremented in the normal manner and

this is continued until the state is equal to $S_{Ho,}$;

when $S_{HR} = S_{HO}$ then the array 1b is incremented a further Q times;

if signals remain constant over the entire period then the signal state is updated to $S_{HOLD}$ and the output value of the device is ascertained.

18. A parallel processing method of logic event simulation as claimed in claim. 17 in which if the output value of the device has changed it is propagated to the fan-out list of the device.

19. A parallel processing method of logic event simulation as claimed in any of claims 16 -18 in which successive states are generated by causing a shift right operation in array 1a.

20. A parallel processing method of logic event simulation as claimed in any preceding claim in which there is provided an amended result registering mechanism in which when a number of tests are carried out on a gate pair the result of each test is sent to a result register where on completion of all the tests the result register will indicate that all tests were successful or that at least one was unsuccessful.

21. A parallel processing method of logic event simulation as claimed in claim 20 in which the result register comprises an adder.

22. A parallel processing method of logic event simulation as claimed in claim 20 in which the result register is a bi-state device.

23. A parallel processing method of logic event simulation as claimed in claim 20 in which the result register comprises a D-flip flop.

24. A parallel processing method of logic event simulation as claimed in any of claims 22 or 23 in which the result register on start-up is supplied with an appropriate priming input instead of last result so that it is ready to receive the first result.

25. A parallel processing method of logic event simulation as claimed in any of claims 20 - 24 in which the amended result registering mechanism further comprises a result polarity circuit to invert a result and ensure a logic 1 is applied to the result register if the correct response to a test was for the test to be failed.

26. A parallel processing method of logic event simulation as claimed in claim 25 in which the result polarity circuit comprises a pair of AND gates, a pair of inverters and an OR gate, a result polarity control is fed to each of the AND gates, the other input of each of the AND gates being provided by the result of a test carried out on a gate pair, the inverters inverting the two inputs to one of the AND gates, the outputs of the AND gates being fed directly to the OR gate.

27. A parallel processing method of logic event simulation as claimed in any of claims 20-26 in which the amended result registering mechanism is further provided with a logic combination circuit to determine whether an output gate pair of array 1b are ANDed or ORed together.

28. A parallel processing method of logic event simulation as claimed in claim 27 in which the logic combination circuit further comprises three AND gates and a logic combination circuit control, the logic combination circuit control being anded individually with each output of an array 1b gate pair and the gate pair anded in the third AND gate, when the logic combination requires an AND operation to be carried out, logic combination circuit control is given a value 0 and if an OR operation is required logic combination circuit control is given a logic value 1.

29. A parallel processing method of logic event simulation as claimed in claim 28 in which the logic combination circuit further comprises an OR gate, each of the ouputs of the three AND gates being fed to the OR gate.

30. A parallel processing method of logic event simulation as claimed in claim 29 in which the output of the OR gate is led to the result polarity circuit as the result of a test carried out on a gate pair.

31. A parallel processing method of logic event simulation as claimed in claims 20 - 30 in which there is provided an amended result registering mechanism for each gate pair.

32. A parallel processing method of logic event simulation as claimed in any preceding claim in which when all active segments have a state > S0, a check of all segment states is made until the lowest segment state $S_{min}$ is found, then each segment state is decremented by $S_{min}$ in order to advance simulation to the next evaluation stage.

33. A parallel processing method of logic event simulation as claimed in claim 32 in which the lowest state value is stored in a low global register and each time there is a gate state change if the new state is less than the low global state register value the low global register state value is replaced by the new state.

34. A parallel processing method of logic event simulation as claimed in any preceding claim in which there is provided a scan system comprising a priority decoder and a shift register.

35. A parallel processing method of logic event simulation as claimed in any preceding claim in which there is provided a segment address table and the segment address table is divided into a number of rows, each row being M bits long, and each segment address is stored in the most significant M - D bits of the segment row when the number of segments = $2^D$.

36. A processor for parallel processing of logic event simulation on circuits comprising a plurality of logic gates, the logic gates having interconnect lines therebetween, the processor further comprising a main processor and an associative memory mechanism, the associative memory mechanism comprising a plurality of associative arrays and at least one result register, wherein there is provided accessible external memory for storage of a circuit representation; **characterised by**:

means to divide the circuit representation into a plurality of circuit segments; means to allocate a circuit segment identifier to each circuit segment, each circuit segment identifier having circuit segment data associated therewith; the associative memory mechanism comprising a segment table for storage of segment identifiers and segment data; means to identify active segments in any one time interval based on the segment data; and means to retrieve those active segments from external memory for evaluation by the associative memory mechanism.

37. A processor as claimed in claim 36 in which the segment data further comprises the maximum time delay for a gate in that segment to undergo a transition.

38. A processor as claimed in claim 36 or 37 in which the associative memory mechanism further comprises a pair of associative arrays (1a and 1b), an input value register and a hit list.

39. A processor as claimed in claim 38 in which cache data of associative array 1a and associative array 1b are stored in external memory during evaluation.

40. A processor as claimed in any of claims 36 - 39 in which after evaluation of the segment data the segments fan-out lists are updated.

41. A processor as claimed in any of claims 36 - 40 in which all interconnect lines are held in a segment dedicated to interconnect lines.

42. A processor as claimed in any of claims 36 - 41 in which all logic gates of a particular type are held in segments with logic gates of the same type.

43. A processor as claimed in any of claims 38 - 42 in which the segment table is an $N_S$ x M bit segment table where $N_s$ is equal to the number of segments and M is equal to the sum of all the number of bits width of associative array 1a, associative array 1b, input value register and the hit list.

44. A processor as claimed in any of claims 38 - 43 in which the set up time, $T_{SETUP}$, of synchronous devices may be modelled and in which $T_{SETUP}$ = N.p + M, where N is equal to an integer, M is equal to an integer < P, and P is equal to the bit width of array 1b, in which:

the state entry in array 1a of this signal is set to $S_{SN}$;

a start marker is placed in the left-most position of array 1b;

array 1b is incremented in the normal manner and when the start marker reaches the right-most position of array 1b and the signal has remained constant the state $S_{SN}$ is decremented to $S_{SN-1}$, and the next time array 1b is incremented the start marker is returned to the left-most position in array 1b once again and the array 1b is then incremented in the normal manner;

the previous step is repeated until state entry = $S_{S0}$, then the array 1b is incremented another M times; and

if the signal has remained constant for N.p + M time units then the state entry in array 1a is set to state setup, $S_{SETUP}$.

45. A processor as claimed in claim 44 in which the hold time, $T_{HOLD}$, of synchronous devices may be modelled where $T_{HOLD} = R.p + Q$, and where R is an integer, Q is an integer < P and P is equal to the bit width of array 1b, in which:-

when a clock makes a transition there is a search of state entries in array 1a to see if any input signals are in state $S_{SETUP}$;

states in $S_{SETUP}$ are updated to the state $S_{HR}$, and a start marker is placed in the left-most position of array 1b, array 1b is incremented in the normal manner until the start marker has made its way to the right-most position in array 1b and the signal has remained constant;

the state is decremented to $S_{HR-1}$, and the next time array 1b is incremented start marker is returned to the left-most position in array 1b, array 1b is then incremented in the normal manner and this is continued until the state is equal to $S_{H0}$ ;

when $S_{HR}$ equals $S_{H0}$ then the array 1b is incremented a further Q times;

if signals remain constant over the entire period then the signal state is updated to $S_{HOLD}$ and the output value of the device is ascertained.

46. A processor as claimed in claim 45 in which if the output value has changed, it is propagated to the fan-out list of the device.

47. A processor as claimed in claims 36 - 46 in which there is provided an amended result registering mechanism in which when a number of tests are carried out on the gate pair the result of each test is sent to a result register where on completion of all the test the result register output will indicate that all tests are successful or that at least one test was unsuccessful.

48. A processor as claimed in claim 47 in which the result register comprises an adder.

49. A processor as claimed in claim 47 in which the result register is a bi-state device.

50. A processor as claimed in claim 47 in which the result register comprises a D-flip flop.

51. A processor as claimed in any of claims 49 - 50 in which the result register on start-up is supplied with an appropriate priming input instead of last result so that it is ready to receive the first actual result.

52. A processor as claimed in any of claims 47 - 51 in which the amended result registering mechanism further comprises a result polarity circuit to invert a result and ensure logic 1 is applied to the result register if the correct response to a test was that a particular test on a gate pair was to be failed

53. A processor as claimed in any of claims 47 - 52 in which the amended result register mechanism is further provided with a logic combination circuit to determine whether an output gate pair of array 1b are ANDed or ORed together.

54. A processor as claimed in claim 53 in which logic combination circuit further comprises three AND gates and a logic combination circuit control, the logic circuit control being anded individually with each output of array 1b gate pair, and the gate pair ANDed in the third AND gate, when the logic combination requires an AND operation, logic combination circuit control is given a value 0 and when an OR operation is required logic combination circuit control is given a logic 1.

55. A processor as claimed in claim 54 in which the logic combination circuit further comprises an OR gate, each of the outputs of the three and gates being fed to the OR gate.

56. A processor as claimed in claim 55 in which the output of the OR gate is led to the result polarity circuit.

57. A processor as claimed in any of claims 36 - 56 in which when all active segments have a state > S0, a check of all segment states is made until the lowest segment state $S_{min}$ is found, then each segment state is decremented by $S_{min}$ in order to advance simulation to the next evaluation stage.

58. A processor as claimed in claim 57 In which the lowest state value is stored on a low global register and each time there is a gate state change if the new state is less than the low global state register value it replaces the low global state register value.

**59.** A processor as claimed in any of claims 36 - 58 in which there is provided a scan system comprising a priority decoder and a shift register.

**60.** A processor as claimed in any of claims 47 - 59 in which there is provided an amended result registering mechanism for each gate pair.

**61.** A processor as claimed in any of claims 36 - 60 in which there is provided a segment address table and the segment address table is divided into a number of rows, each row being M bits long, and each segment address is stored in the most significant M-D bits of the segment row when the number of segments is equal to $2^D$.

**62.** A processor as claimed in any of claims 36 - 61 in which the processor is embodied in computer readable format.

**63.** A processor as claimed in claim 62 in which the processor in computer readable format is stored on a disc.

**64.** A processor as claimed in claim 62 in which the processor in computer readable format is stored on a record medium.

**Patentansprüche**

**1.** Parallelverarbeitungsverfahren für Logikereignissimulation in Schaltkreisen, die eine Vielzahl von Logikgattern umfassen, wobei die Logikgatter Verbindungsleitungen dazwischen aufweisen und das Verfahren in einem Hauptprozessor und einem assoziativen Speichermechanismus ausgeführt wird, wobei der assoziative Speichermechanismus eine Vielzahl von assoziativen Feldern und mindestens ein Ergebnisregister umfasst, wobei ein externer Speicher und ein Mittel bereitgestellt sind, um Daten zwischen dem assoziativen Speicher und dem externen Speicher zu übertragen, wobei das Verfahren folgende Schritte umfasst:

Speichern einer Schaltkreisdarstellung im externen Speicher;
**gekennzeichnet dadurch, dass** es des Weiteren folgende Schritte umfasst:

Unterteilen der Schaltkreisdarstellung in eine Vielzahl von Schaltkreissegmenten; jedem Segment ein eindeutiges Segmentetikett zuweisen; Erzeugen einer Schaltkreissegmenttabelle in dem assoziativen Speicher und Speichern der eindeutigen Segmentetikette zusammen mit Segmentdaten in einer Schaltkreissegmenttabelle; basierend auf den in der Schaltkreissegmenttabelle gespeicherten Segmentdaten Identifizieren von Segmenten für jede Zeitspanne, welche in dieser Zeitspanne aktiv sein können; und aktive Segmente zur Bewertung aus dem externen Speicher in den assoziativen Speichermechanismus bringen.

**2.** Parallelverarbeitungsverfahren für Logikereignissimulation nach Anspruch 1, wobei die in der Schaltkreissegmenttabelle gespeicherten Segmentdaten den Höchstverzögerungszustand eines Segment umfassen, welcher die maximale zeitliche Verzögerung anzeigt, mit der ein beliebiges Gatter in diesem Segment einen Übergang durchführen kann.

**3.** Parallelverarbeitungsverfahren für Logikereignissimulation nach Anspruch 1 und 2, wobei der assoziative Speichermechanismus ein Paar assoziative Felder, das assoziative Feld 1a und das assoziative Feld 1b, eine Eingabewertregisterbank und eine Trefferliste umfasst.

**4.** Parallelverarbeitungsverfahren für Logikereignissimulation nach Anspruch 3, wobei die Schaltkreissegmenttabellendaten des assoziativen Felds 1a und des assoziativen Felds 1b sowie die Eingabewertregisterbank während der Segmentbewertung im externen Speicher gespeichert werden.

**5.** Parallelverarbeitungsverfahren für Logikereignissimulation nach einem der vorhergehenden Ansprüche, wobei nach der Bewertung eines Segments die Segmentdaten aller seiner Ausgangsfächerungsgatter aktualisiert werden.

**6.** Parallelverarbeitungsverfahren für Logikereignissimulation nach Anspruch 5, wobei die Segmentdaten, wenn ein neuer Höchstverzögerungszustand größer als der vorhergehende Höchstverzögerungszustand eines Ausgangsfächerungssegments ist, mit dem neuen Höchstverzögerungszustand aktualisiert werden.

**7.** Parallelverarbeitungsverfahren für Logikereignissimulation nach einem der vorhergehenden Ansprüche, wobei inaktive Segmente nicht zur Bewertung in den assoziativen Speichermechanismus gebracht werden, bevor sie einer Eingabeveränderung zu einem Gatter in diesem Segment unterzogen worden sind.

**8.** Parallelverarbeitungsverfahren für Logikereignissimulation nach einem der vorhergehenden Ansprüche, wobei sämtliche Verbindungsleitungen in einem Segment gehalten werden, das für Verbindungsleitungen bestimmt ist.

9. Parallelverarbeitungsverfahren für Logikereignissimulation nach einem der vorhergehenden Ansprüche, wobei sämtliche Logikgatter eines bestimmten Typs in Segmenten mit Logikgattern desselben Typs gehalten werden.

10. Parallelverarbeitungsverfahren für Logikereignissimulation nach einem der Ansprüche 3 bis 9, wobei die Segmenttabelle eine Segmenttabelle von $N_S$ x M Bits ist, wobei $N_S$ der Anzahl von Segmenten entspricht und M der Summe der Anzahl von Bitweiten des assoziativen Felds 1a, des assoziativen Felds 1b, des Eingabewertregisters und der Trefferliste ist.

11. Parallelverarbeitungsverfahren für Logikereignissimulation nach einem der Ansprüche 5 bis 10, wobei mindestens ein Teil des assoziativen Felds 1a, des assoziativen Felds 1b, der Eingabewertregisterbank und der Trefferliste dafür verwendet werden, die Segmenttabelle jederzeit zu speichern.

12. Parallelverarbeitungsverfahren für Logikereignissimulation nach einem der Ansprüche 3 bis 11, wobei das vorangehende Segmenttabellenverlaufsprotokoll, wenn die Gatterbewertungen für ein bestimmtes Zeitintervall abgeschlossen sind, in des assoziativen Felds 1b gespeichert wird.

13. Parallelverarbeitungsverfahren für Logikereignissimulation nach einem der Ansprüche 3 bis 12, wobei die Eingabewertregisterbank in das assoziative Feld 1b verlegt wird und das assoziative Feld 1a den Höchstzustand jedes Segments enthält, woraufhin Testmuster auf Inhalte des Felds 1b angewendet werden, um Übergänge in niedrigere Zustände festzustellen.

14. Parallelverarbeitungsverfahren für Logikereignissimulation nach einem der vorhergehenden Ansprüche, wobei Segmente im Zustand $S_0$ zur Bewertung eingeholt werden.

15. Parallelverarbeitungsverfahren für Logikereignissimulation nach einem der vorhergehenden Ansprüche, wobei der Mindestzustand sämtlicher Segmente, $S_{MINZUST}$, berechnet wird und sämtliche Zustände um $S_{MINZUST}$ Zeiteinheiten zeitlich vorverlegt werden, bevor die Bewertung der Segmente beginnt.

16. Parallelverarbeitungsverfahren für Logikereignissimulation nach einem der Ansprüche 3 bis 15, wobei die Einrichtzeit, $T_{EINRICHT}$, von synchronen Vorrichtungen modelliert werden kann, wobei $T_{EINRICHT}$=N.p + M, wobei N=Ganzzahl, M=Ganzzahl < P und P=Bitbreite von Feld 1b, wobei durch die folgenden Schritte:

der Zustandseintrag von Feld 1a dieses Signals auf $S_{sn}$ eingestellt wird; ein Startkennzeichen in der äußersten linken Position des Felds 1b angeordnet wird; das Feld 1b in gewöhnlicher Weise zeitlich inkrementiert wird und, wenn das Startkennzeichen die äußerste rechte Position des Felds 1b erreicht und das Signal konstant geblieben ist, der Zustand $S_{sn}$ auf $S_{sn-1}$ dekrementiert wird, und das nächste Mal, wenn das Feld 1b inkrementiert wird, das Startkennzeichen wiederum in die äußerste linke Position in dem Feld 1b zurückgebracht und das Feld 1b daraufhin in gewöhnlicher Weise inkrementiert wird; der vorangehende Schritt wiederholt wird, bis der Zustandseintrag $S_{sn}=S_{so}$, daraufhin wird das Feld 1b wiederum M mal inkrementiert; und wenn das Signal N.p + M Zeiteinheiten lang konstant geblieben ist, dann wird der Zustandseintrag in dem Feld 1a auf die Zustandseinrichtung $S_{EINRICHT}$ eingestellt.

17. Parallelverarbeitungsverfahren für Logikereignissimulation nach einem der Ansprüche 3 bis 16, wobei die Haltezeit $T_{HALTE}$ synchroner Vorrichtungen modelliert werden kann, wobei $T_{HALTE}$ = R.p + Q und wobei R = Ganzzahl, Q = Ganzzahl < P und P = Bitbreite von Feld 1b, unter Verwendung der folgenden Schritte:

wenn ein Taktgeber einen Übergang durchführt, findet eine Durchsuchung der Zustandseinträge in dem Feld 1a statt, um festzustellen, ob sich irgendwelche Eingabesignale im Zustand $S_{EINRICHT}$ befinden; Zustände in $S_{EINRICHT}$ werden in den Zustand $S_{HR}$ aktualisiert und ein Startkennzeichen wird in der äußersten linken Position von Feld 1b angeordnet, das Feld 1b wird in gewöhnlicher Weise inkrementiert, bis das Kennzeichen in die äußerste rechte Position in Feld 1b gerückt ist und das Signal konstant geblieben ist; der Zustand wird auf $S_{HR-1}$ dekrementiert, das Startkennzeichen wird das nächste Mal, wenn das Feld 1b inkrementiert wird, in die äußerste linke Position in dem Feld 1b zurückgebracht, daraufhin wird das Feld 1b in gewöhnlicher Weise inkrementiert und dies wird fortgesetzt, bis der Zustand $S_{H0}$ entspricht; wenn $S_{HR}=S_{H0}$, dann wird das Feld 1b wiederum Q mal inkrementiert; wenn Signale die gesamte Zeitperiode lang konstant bleiben, dann wird der Signalzustand zu $S_{HALTE}$ aktualisiert und der Ausgabewert der Vorrichtung wird ermittelt.

**18.** Parallelverarbeitungsverfahren für Logikereignissimulation nach Anspruch 17, wobei der Ausgabewert der Vorrichtung, falls er sich geändert hat, zur Ausgangsfächerungsliste der Vorrichtung weitergeleitet wird.

**19.** Parallelverarbeitungsverfahren für Logikereignissimulation nach einem der Ansprüche 16 - 18, wobei aufeinanderfolgende Zustände erzeugt werden, indem ein Nach-Rechts-Rück-Vorgang in dem Feld 1a veranlasst wird.

**20.** Parallelverarbeitungsverfahren für Logikereignissimulation nach einem der vorhergehenden Ansprüche, wobei ein Registriermechanismus für abgeänderte Ergebnisse geschaffen wird, wobei, wenn eine Anzahl von Tests an einem Gatterpaar ausgeführt wird, das Ergebnis jedes Tests zu einem Ergebnisregister gesendet wird, wobei bei Abschluss sämtlicher Tests das Ergebnisregister anzeigt, dass sämtliche Tests erfolgreich waren oder dass mindestens einer nicht erfolgreich war.

**21.** Parallelverarbeitungsverfahren für Logikereignissimulation nach Anspruch 20, wobei das Ergebnisregister einen Addierer umfasst.

**22.** Parallelverarbeitungsverfahren für Logikereignissimulation nach Anspruch 20, wobei das Ergebnisregister eine Bi-Zustandsvorrichtung ist.

**23.** Parallelverarbeitungsverfahren für Logikereignissimulation nach Anspruch 20, wobei das Ergebnisregister eine bistabile D-Kippschaltung umfasst.

**24.** Parallelverarbeitungsverfahren für Logikereignissimulation nach einem der Ansprüche 22 oder 23, wobei das Ergebnisregister beim Start anstelle des letzten Ergebnisses mit einer geeigneten Vorbereitungseingabe versorgt wird, so dass es bereit ist, das erste Ergebnis zu empfangen.

**25.** Parallelverarbeitungsverfahren für Logikereignissimulation nach einem der Ansprüche 20 - 24, wobei der Registriermechanismus für abgeänderte Ergebnisse des Weiteren einen Ergebnispolaritätsschaltkreis umfasst, um ein Ergebnis umzukehren, und sicherzustellen, dass eine logische 1 an das Ergebnisregister angelegt wird, wenn die korrekte Reaktion auf einen Test lautete, dass der Test fehlgeschlagen hat.

**26.** Parallelverarbeitungsverfahren für Logikereignissimulation nach Anspruch 25, wobei der Ergebnispolaritätsschaltkreis ein Paar UND-Gatter, ein Paar Umkehrer und ein ODER-Gatter umfasst, eine Ergebnispolaritätssteuerung an jedes der UND-Gatter angelegt wird, die andere Eingabe jedes der UND-Gatter von dem Ergebnis eines Tests bereitgestellt wird, der an einem Gatterpaar durchgeführt wird, die Umkehrer die beiden Eingaben zu einem der UND-Gatter umkehren und die Ausgaben der UND-Gatter direkt an das ODER-Gatter angelegt werden.

**27.** Parallelverarbeitungsverfahren für Logikereignissimulation nach einem der Ansprüche 20 - 26, wobei der Registriermechanismus für abgeänderte Ergebnisse des Weiteren mit einem Logikkombinationsschaltkreis ausgestattet ist, um zu bestimmen, ob ein Ausgabegatterpaar des Felds 1b durch UND oder ODER zusammengefügt ist.

**28.** Parallelverarbeitungsverfahren für Logikereignissimulation nach Anspruch 27, wobei der Logikkombinationsschaltkreis des Weiteren drei UND-Gatter und eine Logikkombinationsschaltkreissteuerung umfasst, wobei die Logikkombinationsschaltkreissteuerung mit jeder Ausgabe eines Gatterpaars des Felds 1b einzeln UND-geschaltet ist und das Gatterpaar im dritten UND-Gatter UND-geschaltet ist, wobei, wenn die Logikkombination erfordert, dass ein UND-Vorgang ausgeführt wird, der Logikkombinationsschaltkreissteuerung ein Wert 0 zugewiesen wird, und wenn ein ODER-Vorgang erforderlich ist, der Logikkombinationsschaltkreissteuerung ein logischer Wert 1 zugewiesen wird.

**29.** Parallelverarbeitungsverfahren für Logikereignissimulation nach Anspruch 28, wobei der Logikkombinationsschaltkreis des Weiteren ein ODER-Gatter umfasst, wobei jede der Ausgaben der drei UND-Gatter an das ODER-Gatter angelegt wird.

**30.** Parallelverarbeitungsverfahren für Logikereignissimulation nach Anspruch 29, wobei die Ausgabe des ODER-Gatters als Ergebnis eines Tests, der an einem Gatterpaar durchgeführt wird, zum Ergebnispolaritätsschaltkreis geleitet wird.

**31.** Parallelverarbeitungsverfahren für Logikereignissimulation nach einem der Ansprüche 20 - 30, wobei ein Registriermechanismus für abgeänderte Ergebnisse für jedes Gatterpaar bereitgestellt ist.

**32.** Parallelverarbeitungsverfahren für Logikereignissimulation nach einem der vorhergehenden Ansprüche, wobei, wenn sämtliche aktiven Segmente einen Zustand > S0 aufweisen, eine Überprüfung sämtlicher Segmentzustände durchgeführt wird, bis der niedrigste Segmentzustand $S_{min}$ gefunden wird, woraufhin jeder Segmentzustand um $S_{min}$ dekrementiert wird, um die Simulation zum nächsten Bewertungszustand weiterzuführen.

**33.** Parallelverarbeitungsverfahren für Logikereignissimulation nach Anspruch 32, wobei der geringste Zustandswert in einem globalen Niedrigregister gespeichert wird und jedes Mal, wenn eine Gatterzustandsänderung vorliegt und der neue Zustand geringer ist als der globale Niedrigzustandsregisterwert, der globale Niedrigzustandsregisterwert durch den neuen Zustand ersetzt wird.

34. Parallelverarbeitungsverfahren für Logikereignissimulation nach einem der vorhergehenden Ansprüche, wobei ein Abtastsystem bereitgestellt wird, das einen Prioritätsdecodierer und ein Verschiebungsregister umfasst.

35. Parallelverarbeitungsverfahren für Logikereignissimulation nach einem der vorhergehenden Ansprüche, wobei eine Segmentadressentabelle bereitgestellt wird und die Segmentadressentabelle in eine Anzahl von Zeilen unterteilt ist, wobei jede Zeile M Bits lang ist, und jede Segmentadresse in den höchstwertigen M-D Bits der Segmentzeile gespeichert wird, wenn die Anzahl von Segmenten = $2^D$ ist.

36. Prozessor zur Parallelverarbeitung von Logikereignissimulation in Schaltkreisen, der eine Vielzahl von Logikgattern umfasst, wobei die Logikgatter Verbindungsleitungen dazwischen aufweisen und der Prozessor des Weiteren einen Hauptprozessor und einen assoziativen Speichermechanismus umfasst, wobei der assoziative Speichermechanismus eine Vielzahl von assoziativen Feldern und mindestens ein Ergebnisregister umfasst, wobei
ein externer Speicher, auf den zugegriffen werden kann, zur Speicherung einer Schaltkreisdarstellung bereitgestellt ist;
**gekennzeichnet:**

> **durch** ein Mittel zum Unterteilen der Schaltkreisdarstellung in eine Vielzahl von Schaltkreissegmenten;
> **durch** ein Mittel zum Zuweisen eines Schaltkreissegmentetiketts zu jedem Schaltkreissegment, wobei jedem Schaltkreissegmentetikett Schaltkreissegmentdaten zugeordnet sind;
> **durch** den assoziativen Speichermechanismus, der eine Segmenttabelle zur Speicherung von Segmentetiketten und Segmentdaten umfasst;
> **durch** ein Mittel zum Identifizieren von aktiven Segmenten in jedem beliebigen Zeitintervall basierend auf den Segmentdaten; und
> **durch** ein Mittel zum Abrufen dieser aktiven Segmente aus dem externen Speicher zur Bewertung durch den assoziativen Speichermechanismus.

37. Prozessor nach Anspruch 36, wobei die Segmentdaten des Weiteren die maximale zeitliche Verzögerung umfassen, mit der ein Gatter in diesem Segment einen Übergang durchführen kann.

38. Prozessor nach Anspruch 36 oder 37, wobei der assoziative Speichermechanismus des Weiteren ein Paar assoziative Felder (1a und 1b), ein Eingabewertregister und eine Trefferliste umfasst.

39. Prozessor nach Anspruch 38, wobei Cache-Daten des assoziativen Felds 1a und des assoziativen Felds 1b während der Bewertung im externen Speicher gespeichert werden.

40. Prozessor nach einem der Ansprüche 36 - 39, wobei nach der Bewertung der Segmentdaten die Segmentausgangsfächerungslisten aktualisiert werden.

41. Prozessor nach einem der Ansprüche 36 - 40, wobei sämtliche Verbindungsleitungen in einem Segment gehalten werden, das für Verbindungsleitungen bestimmt ist.

42. Prozessor nach einem der Ansprüche 36 - 41, wobei sämtliche Logikgatter eines bestimmten Typs in Segmente mit Logikgattern desselben Typs gehalten werden.

43. Prozessor nach einem der Ansprüche 38 - 42, wobei die Segmenttabelle eine Segmenttabelle von $N_s$ x M Bits ist, wobei $N_s$ der Anzahl von Segmenten entspricht und M der Summe der ganzen Anzahl von Bitweiten des assoziativen Felds 1a, des assoziativen Felds 1b, des Eingabewertregisters und der Trefferliste entspricht.

44. Prozessor nach einem der Ansprüche 38 - 43, wobei die Einrichtzeit $T_{EINRICHT}$ synchroner Vorrichtungen modelliert werden kann und wobei $T_{EINRICHT}$=N.p + M, wobei N=Ganzzahl, M=Ganzzahl < P und P=Bitbreite von Feld 1b, wobei:

> der Zustandseintrag von Feld 1a dieses Signals auf $S_{SN}$ eingestellt wird;
> ein Startkennzeichen in der äußersten linken Position des Felds 1b angeordnet wird;
> das Feld 1b in gewöhnlicher Weise inkrementiert wird und, wenn das Startkennzeichen die äußerste rechte Position des Felds 1b erreicht und das Signal konstant geblieben ist, der Zustand $S_{SN}$, auf $S_{SN-1}$ dekrementiert wird, und das nächste Mal, wenn das Feld 1b inkrementiert wird, das Startkennzeichen wiederum in die äußerste linke Position in dem Feld 1b zurückgebracht wird und das Feld 1b daraufhin in gewöhnlicher Weise inkrementiert wird;
> der vorangehende Schritt wiederholt wird, bis der Zustandseintrag $S_{so}$ beträgt, woraufhin das Feld 1b wiederum M mal inkrementiert wird; und wenn das Signal N.p + M Zeiteinheiten lang konstant geblieben ist, der Zustandseintrag daraufhin in dem Feld 1a auf die Zustandseinrichtung $S_{EINRICHT}$ eingestellt wird.

45. Prozessor nach Anspruch 44, wobei die Haltezeit $T_{HALTE}$ synchroner Vorrichtungen modelliert werden kann, wobei $T_{HALTE}$ = R.p + Q und wobei R = Ganzzahl, Q = Ganzzahl < P und P der Bitbreite von Feld 1b entspricht, wobei:

wenn ein Taktgeber einen Übergang durchführt, findet eine Durchsuchung der Zustandseinträge in dem Feld 1a statt, um festzustellen, ob sich irgendwelche Eingabesignale im Zustand $S_{EINRICHT}$ befinden;
Zustände in $S_{EINRICHT}$ werden in den Zustand $S_{HR}$ aktualisiert und ein Startkennzeichen wird in der äußersten linken Position von Feld 1b angeordnet, das Feld 1b wird in gewöhnlicher Weise inkrementiert, bis das Startkennzeichen in die äußerste rechte Position in Feld 1b gerückt und das Signal konstant geblieben ist;
der Zustand wird auf $S_{HR-1}$ dekrementiert, das Startkennzeichen wird das nächste Mal, wenn das Feld 1b inkrementiert wird, in die äußerste linke Position in dem Feld 1b zurückgebracht, daraufhin wird das Feld 1b in gewöhnlicher Weise inkrementiert und dies wird fortgesetzt, bis der Zustand $S_{H0}$ entspricht;
wenn $S_{HR}$=$S_{H0}$, dann wird das Feld 1b wiederum Q mal inkrementiert;
wenn die Signale die gesamte Periode lang konstant bleiben, dann wird der Signalzustand zu $S_{HALTE}$ aktualisiert und der Ausgabewert der Vorrichtung wird ermittelt.

46. Prozessor nach Anspruch 45, wobei der Ausgabewert, falls er sich geändert hat, zur Ausgangsfächerungsliste der Vorrichtung weitergeleitet wird.

47. Prozessor nach einem der Ansprüche 36 - 46, wobei ein Registriermechanismus für abgeänderte Ergebnisse geschaffen wird, wobei, wenn eine Anzahl von Tests an dem Gatterpaar ausgeführt wird, das Ergebnis jedes Tests zu einem Ergebnisregister gesendet wird, wobei bei Abschluss sämtlicher Tests die Ergebnisregisterausgabe anzeigt, dass sämtliche Tests erfolgreich waren oder dass mindestens ein Test nicht erfolgreich war.

48. Prozessor nach Anspruch 47, wobei das Ergebnisregister einen Addierer umfasst.

49. Prozessor nach Anspruch 47, wobei das Ergebnisregister eine Bi-Zustandsvorrichtung ist.

50. Prozessor nach Anspruch 47, wobei das Ergebnisregister eine bistabile D-Kippschaltung umfasst.

51. Prozessor nach einem der Ansprüche 49 - 50, wobei das Ergebnisregister beim Start anstelle des letzten Ergebnisses mit einer geeigneten Vorbereitungseingabe versorgt wird, so dass es bereit ist, das erste tatsächliche Ergebnis zu empfangen.

52. Prozessor nach einem der Ansprüche 47 - 51, wobei der Registriermechanismus für abgeänderte Ergebnisse des Weiteren einen Ergebnispolaritätsschaltkreis umfasst, um ein Ergebnis umzukehren, und sicherzustellen, dass eine logische 1 an das Ergebnisregister angelegt wird, wenn die korrekte Reaktion auf einen Test lautete, dass ein bestimmter Test an einem Gatterpaar fehlgeschlagen hat.

53. Prozessor nach einem der Ansprüche 47 - 52, wobei der Registriermechanismus für abgeänderte Ergebnisse des Weiteren mit einem Logikkombinationsschaltkreis ausgestattet ist, um zu bestimmen, ob ein Ausgabegatterpaar des Felds 1b durch UND oder ODER zusammengefügt ist.

54. Prozessor nach Anspruch 53, wobei der Logikkombinationsschaltkreis des Weiteren drei UND-Gatter und eine Logikkombinationsschaltkreissteuerung umfasst, wobei die Logikschaltkreissteuerung mit jeder Ausgabe eines Gatterpaars des Felds 1b einzeln UND-geschaltet ist und das Gatterpaar im dritten UND-Gatter UND-geschaltet ist, wobei, wenn die Logikkombination erfordert, dass ein UND-Vorgang ausgeführt wird, der Logikkombinationsschaltkreissteuerung ein Wert 0 zugewiesen wird, und wenn ein ODER-Vorgang erforderlich ist, der Logikkombinationsschaltkreissteuerung ein logischer Wert 1 zugewiesen wird.

55. Prozessor nach Anspruch 54, wobei der Logikkombinationsschaltkreis des Weiteren ein ODER-Gatter umfasst, wobei jede der Ausgaben der drei UND-Gatter an das ODER-Gatter angelegt wird.

56. Prozessor nach Anspruch 55, wobei die Ausgabe des ODER-Gatters zum Ergebnispolaritätsschaltkreis geleitet wird.

57. Prozessor nach einem der Ansprüche 36 - 56, wobei, wenn sämtliche aktiven Segmente einen Zustand > S0 aufweisen, eine Überprüfung sämtlicher Segmentzustände durchgeführt wird, bis der niedrigste Segmentzustand $S_{min}$ gefunden wird, woraufhin jeder Segmentzustand um $S_{min}$ dekrementiert wird, um die Simulation zum nächsten Bewertungszustand weiterzuführen.

58. Prozessor nach Anspruch 57, wobei der geringste Zustandswert in einem globalen Niedrigregister gespeichert wird und jedes Mal, wenn eine Gatterzustandsänderung vorliegt und der neue Zustand geringer ist als der globale Niedrigzustandsregisterwert, ersetzt er den globalen Niedrigregisterzustandswert.

**59.** Prozessor nach einem der Ansprüche 36 - 58, wobei ein Abtastsystem bereitgestellt wird, das einen Prioritätsdecodierer und ein Verschiebungsregister umfasst.

**60.** Prozessor nach einem der Ansprüche 47 - 59, wobei ein Registriermechanismus für abgeänderte Ergebnisse für jedes Gatterpaar bereitgestellt ist.

**61.** Prozessor nach einem der Ansprüche 36 - 60, wobei eine Segmentadressentabelle bereitgestellt wird und die Segmentadressentabelle in eine Anzahl von Zeilen unterteilt ist, wobei jede Zeile M Bits lang ist, und jede Segmentadresse in den höchstwertigen M-D Bits der Segmentzeile gespeichert wird, wenn die Anzahl von Segmenten = $2^D$ ist.

**62.** Prozessor nach einem der Ansprüche 36 - 61, wobei der Prozessor in einem computerlesbaren Format verwirklicht ist.

**63.** Prozessor nach Anspruch 62, wobei der Prozessor in computerlesbarem Format auf einer Platte gespeichert ist.

**64.** Prozessor nach Anspruch 62, wobei der Prozessor in computerlesbarem Format auf einem Aufzeichnungsmedium gespeichert ist.

**Revendications**

**1.** Procédé de traitement parallèle de simulation d'événements logiques sur des circuits comprenant une pluralité de portes logiques, les portes logiques ayant des lignes d'interconnexion entre elles, le procédé étant exécuté dans un processeur principal et un mécanisme de mémoire associative, le mécanisme de mémoire associative comprenant une pluralité de matrices associatives et au moins un registre de résultats, dans lequel :

sont fournis une mémoire externe et un moyen pour transférer les données entre la mémoire associative et la mémoire externe, le procédé comprenant l'étape consistant à :

mémoriser une représentation de circuit dans la mémoire externe ;
**caractérisé en ce que** qu'il comprend en outre les étapes consistant à :

diviser la représentation de circuit en une pluralité de segments de circuit ;

assigner un identifiant de segment unique à chaque segment ;
générer une table de segments de circuit dans la mémoire associative et mémoriser les identifiants de segments uniques avec des données de segments dans une table de segments de circuit ;
pendant chaque période temporelle, identifier les segments qui sont éventuellement actifs dans cette période temporelle d'après les données de segments mémorisées dans la table de segments de circuit ; et
amener les segments actifs dans le mécanisme de mémoire associative depuis la mémoire externe en vue de leur évaluation.

**2.** Procédé de traitement parallèle de simulation d'événements logiques selon la revendication 1, dans lequel les données de segments mémorisées dans la table de segments de circuit comprend l'état de retard maximum d'un segment, lequel indique le retard maximum avec lequel n'importe quelle porte dans ce segment peut effectuer une transition.

**3.** Procédé de traitement parallèle de simulation d'événements logiques selon les revendications 1 et 2, dans lequel le mécanisme de mémoire associative comprend une paire de matrices associatives, matrice associative 1a et matrice associative 1b, un bloc de registre de valeurs d'entrée et une liste de réponses positives.

**4.** Procédé de traitement parallèle de simulation d'événements logiques selon la revendication 3, dans lequel les données de la table de segments de circuit de la matrice associative 1a, de la matrice associative 1b et du bloc de registre de valeurs d'entrée sont mémorisées dans la mémoire externe durant l'évaluation des segments.

**5.** Procédé de traitement parallèle de simulation d'événements logiques selon l'une quelconque des revendications précédentes, dans lequel après l'évaluation d'un segment, les données de segments de toutes ses portes de sortance sont mises à jour.

**6.** Procédé de traitement parallèle de simulation d'événements logiques selon la revendication 5, dans lequel quand un nouvel état de retard maximum est supérieur à l'état de retard maximum antérieur d'un segment de sortance, les données de segments sont mises à jour avec le nouvel état de retard maximum.

**7.** Procédé de traitement parallèle de simulation d'événements logiques selon l'une quelconque des revendications précédentes, dans lequel les segments inactifs ne sont pas amenés dans le mécanisme de mémoire associative en vue de leur évaluation tant qu'ils n'ont pas subi un changement d'entrée dans une porte dans ce segment.

8. Procédé de traitement parallèle de simulation d'événements logiques selon l'une quelconque des revendications précédentes, dans lequel toutes les lignes d'interconnexion sont contenues dans un segment dédié aux lignes d'interconnexion.

9. Procédé de traitement parallèle de simulation d'événements logiques selon l'une quelconque des revendications précédentes, dans lequel toutes les portes logiques d'un type particulier sont contenues dans des segments aux portes logiques du même type.

10. Procédé de traitement parallèle de simulation d'événements logiques selon l'une quelconque des revendications 3 à 9, dans lequel la table de segments est une table de segments de $N_S$ x M bits, où $N_S$ est égal au nombre de segments et M est égal à la somme du nombre de bits de large de la matrice associative 1a, de la matrice associative 1b, du registre de valeurs d'entrée et de la liste de réponses positives.

11. Procédé de traitement parallèle de simulation d'événements logiques selon l'une quelconque des revendications 5 à 10, dans lequel au moins une partie de la matrice associative 1a, de la matrice associative 1b, du bloc de registre de valeurs d'entrée et de la liste de réponses positives est utilisée pour mémoriser la table de segments en permanence.

12. Procédé de traitement parallèle de simulation d'événements logiques selon l'une quelconque des revendications 3 à 11, dans lequel quand les évaluations de portes sont terminées pendant un intervalle de temps particulier, l'historique de la table de segments antérieure est mémorisé dans la matrice associative 1b.

13. Procédé de traitement parallèle de simulation d'événements logiques selon l'une quelconque des revendications 3 à 12, dans lequel le bloc de registre de valeurs d'entrée est décalé dans la matrice associative 1b, et la matrice associative 1a contient l'état maximum de chaque segment, des configurations d'essai sont alors appliquées au contenu de la matrice 1b pour déterminer les transitions sur des états inférieurs.

14. Procédé de traitement parallèle de simulation d'événements logiques selon l'une quelconque des revendications précédentes, dans lequel des segments dans l'état $S_0$ sont amenés en vue de leur évaluation.

15. Procédé de traitement parallèle de simulation d'événements logiques selon l'une quelconque des revendications précédentes, dans lequel l'état minimum de tous les segments, $S_{ETATMIN}$, est calculé et tous les états sont avancés dans le temps par $S_{ETATMIN}$ Unités de temps avant que ne commence l'évaluation des segments.

16. Procédé de traitement parallèle de simulation d'événements logiques selon l'une quelconque des revendications 3 à 15, dans lequel le temps d'établissement, $T_{ETABLISSEMENT}$, de dispositifs synchrones peut être modélisé où $T_{ETABLISSEMENT} = N.p + M$, où N = nombre entier, M = nombre entier < P et P = largeur binaire de la matrice 1b, où par les étapes suivantes :

l'entrée d'état de la matrice 1a de ce signal est réglée à $S_{sn}$ ;
un marqueur de début est placé à la position extrême-gauche de la matrice 1b ;
la matrice 1b est incrémentée dans le temps de façon normale et lorsque le marqueur de début atteint la position extrême-droite de la matrice 1b et que le signal est resté constant, l'état $S_{sn}$ est décrémenté à $S_{sn-1}$, et la prochaine fois que la matrice 1b est incrémentée le marqueur de début est ramené à la position extrême-gauche dans la matrice 1b à nouveau et la matrice 1b est alors incrémentée de façon normale ;
l'étape précédente est répétée jusqu'à ce que l'entrée d'état $S_{sn} = S_{s0}$, puis la matrice 1b est incrémentée M autres fois ; et
si le signal est resté constant pendant N.p + M unités de temps, l'entrée d'état dans la matrice 1a est alors réglée sur l'établissement d'état, $S_{ETABLISSEMENT}$.

17. Procédé de traitement parallèle de simulation d'événements logiques selon l'une quelconque des revendications 3 à 16, dans lequel la durée de maintien, $T_{MAINTIEN}$, des dispositifs synchrones peut être modélisée où $T_{MAINTIEN} = R.p + Q$, et où R = nombre entier, Q = nombre entier < P et P = largeur binaire de la matrice 1b en utilisant les étapes suivantes :

quand une horloge effectue une transition, une recherche des entrées d'état est lancée dans la matrice 1a pour voir si un quelconque signal d'entrée se trouve dans l'état $S_{établissement}$ ;
les états dans $S_{établissement}$ sont mis à jour sur l'état $S_{HR}$, et un marqueur de début est placé à la position extrême-gauche de la matrice 1b, la matrice 1b est incrémentée de façon normale et jusqu'à ce que le marqueur soit parvenu à la position extrême-droite dans la matrice 1b et que le signal soit resté constant ;
l'état est décrémenté à $S_{HR-1}$, le marqueur de début est ramené à la position extrême-gauche dans la matrice 1b 1a prochaine fois que la matrice 1b est incrémentée, la matrice 1b est alors incrémentée de façon normale et ceci continue jusqu'à ce que l'état soit égal à $S_{HO}$ ;

quand $S_{HR} = S_{HO}$ la matrice 1b est alors incrémentée Q autres fois ;

si le signal reste constant durant toute la période, l'état du signal est alors mis à jour sur $S_{MAINTIEN}$ et la valeur de sortie du dispositif est déterminée.

18. Procédé de traitement parallèle de simulation d'événements logiques selon la revendication 17, dans lequel si la valeur de sortie du dispositif a changé, elle est propagée à la liste de sortance du dispositif.

19. Procédé de traitement parallèle de simulation d'événements logiques selon l'une quelconque des revendications 16 à 18, dans lequel des états successifs sont générés en causant une opération de décalage vers la droite dans la matrice 1a.

20. Procédé de traitement parallèle de simulation d'événements logiques selon l'une quelconque des revendications précédentes, dans lequel est fourni un mécanisme d'enregistrement de résultats modifiés dans lequel quand un nombre d'essais est effectué sur une paire de portes, le résultat de chaque essai est envoyé à un registre de résultats où au terme de tous les essais, le registre de résultats indiquera que tous les essais ont réussi ou qu'au moins un n'a pas réussi.

21. Procédé de traitement parallèle de simulation d'événements logiques selon la revendication 20, dans lequel le registre de résultats comprend un additionneur.

22. Procédé de traitement parallèle de simulation d'événements logiques selon la revendication 20, dans lequel le registre de résultats est un dispositif à deux états.

23. Procédé de traitement parallèle de simulation d'événements logiques selon la revendication 20, dans lequel le registre de résultats comprend une bascule D.

24. Procédé de traitement parallèle de simulation d'événements logiques selon l'une quelconque des revendications 22 ou 23, dans lequel le registre de résultats reçoit au démarrage une entrée d'amorçage appropriée au lieu du dernier résultat de telle sorte qu'il soit prêt à recevoir le premier résultat.

25. Procédé de traitement parallèle de simulation d'événements logiques selon l'une quelconque des revendications 20 à 24, dans lequel le mécanisme d'enregistrement de résultats modifiés comprend en outre un circuit de polarité de résultat afin d'inverser un résultat et de garantir qu'un 1 logique est appliqué au registre de résultats si la réponse correcte à un essai était un échec de celui-ci.

26. Procédé de traitement parallèle de simulation d'événements logiques selon la revendication 25, dans lequel le circuit de polarité de résultat comprend une paire de portes ET, une paire d'inverseurs et une porte OU, une commande de polarité de résultat est passée à chacune des portes ET, l'autre entrée de chacune des portes ET étant fournie par le résultat d'un essai effectué sur une paire de portes, les inverseurs inversant les deux entrées allant à l'une des portes ET, les sorties des portes ET étant passées directement à la porte OU.

27. Procédé de traitement parallèle de simulation d'événements logiques selon l'une quelconque des revendications 20 à 26, dans lequel le mécanisme d'enregistrement de résultats modifiés est doté en outre d'un circuit de combinaison logique afin de déterminer si une paire de portes de sortie de la matrice 1b font l'objet d'une opération ET ou OU.

28. Procédé de traitement parallèle de simulation d'événements logiques selon la revendication 27, dans lequel le circuit de combinaison logique comprend en outre trois portes ET et une commande de circuit de combinaison logique, la commande de circuit de combinaison logique faisant l'objet d'une opération ET avec chaque sortie d'une paire de portes de la matrice 1b et la paire de portes faisant l'objet d'une opération ET dans la troisième porte ET, quand la combinaison logique exige d'effectuer une opération ET, la commande de circuit de combinaison logique reçoit une valeur 0 et si une opération OU est requise la commande de circuit de combinaison logique reçoit une valeur logique 1.

29. Procédé de traitement parallèle de simulation d'événements logiques selon la revendication 28, dans lequel le circuit de combinaison logique comprend en outre une porte OU, chacune des sorties des trois portes ET étant passée à la porte OU.

30. Procédé de traitement parallèle de simulation d'événements logiques selon la revendication 29, dans lequel la sortie de la porte OU est amenée au circuit de polarité de résultat à la suite d'un essai effectué sur une paire de portes.

31. Procédé de traitement parallèle de simulation d'événements logiques selon les revendications 20 à 30, dans lequel est fourni un mécanisme d'enregistrement de résultats modifiés pour chaque paire de portes.

**32.** Procédé de traitement parallèle de simulation d'événements logiques selon l'une quelconque des revendications précédentes, dans lequel quand tous les segments actifs ont un état > S0, une vérification de tous les états de segments est effectuée jusqu'à ce que l'état de segment le plus bas $S_{min}$ soit trouvé, puis chaque état de segment est décrémenté par $S_{min}$ afin d'avancer la simulation à l'étage d'évaluation suivant.

**33.** Procédé de traitement parallèle de simulation d'événements logiques selon la revendication 32, dans lequel la valeur d'état la plus basse est mémorisée dans un registre global bas et chaque fois qu'il y a un changement d'état de porte si le nouvel état est inférieur à la valeur du registre d'état global bas la valeur du registre d'état global bas est remplacée par le nouvel état.

**34.** Procédé de traitement parallèle de simulation d'événements logiques selon l'une quelconque des revendications précédentes, dans lequel est fourni un système de balayage comprenant un décodeur de priorité et un registre à décalage.

**35.** Procédé de traitement parallèle de simulation d'événements logiques selon l'une quelconque des revendications précédentes, dans lequel est fourni une table d'adresses de segments et la table d'adresses de segments est divisée en un nombre de rangées, chaque rangée étant de M bits de long, et chaque adresse de segment est mémorisée dans les M-D bits de poids fort de la rangée de segment quand le nombre de segments = $2^D$.

**36.** Processeur pour le traitement parallèle de simulation d'événements logiques sur des circuits comprenant une pluralité de portes logiques, les portes logiques ayant des lignes d'interconnexion entre elles, le processeur comprenant en outre un processeur principal et un mécanisme de mémoire associative, le mécanisme de mémoire associative comprenant une pluralité de matrices associatives et au moins un registre de résultats, dans lequel :

est fournie une mémoire externe accessible pour la mémorisation d'une représentation de circuit ;
**caractérisé par** :

un moyen pour diviser la représentation de circuit en une pluralité de segments de circuit ;
un moyen pour assigner un identifiant de segment de circuit à chaque segment de circuit, chaque identifiant de segment de circuit ayant des données de segment de circuit associées ;
le mécanisme de mémoire associative comprenant une table de segments pour la mémorisation des identifiants de segments et des données de segments ;
un moyen pour identifier des segments actifs dans n'importe quel intervalle de temps d'après les données de segments ; et
un moyen pour recouvrer ces segments actifs dans la mémoire externe en vue de leur évaluation par le mécanisme de mémoire associative.

**37.** Processeur selon la revendication 36, dans lequel les données de segments comprennent en outre le retard de temps maximum avec lequel une porte dans ce segment peut subir une transition.

**38.** Processeur selon la revendication 36 ou 37, dans lequel le mécanisme de mémoire associative comprend en outre une paire de matrices associatives (1a et 1b), un registre de valeurs d'entrée et une liste de réponses positives.

**39.** Processeur selon la revendication 38, dans lequel des données d'antémémoire de la matrice associative 1a et de la matrice associative 1b sont mémorisées dans la mémoire externe durant l'évaluation.

**40.** Processeur selon l'une quelconque des revendications 36 à 39, dans lequel après l'évaluation des données de segments, toutes les listes de sortance de segments sont mises à jour.

**41.** Processeur selon l'une quelconque des revendications 36 à 40, dans lequel toutes les lignes d'interconnexion sont contenues dans un segment dédié aux lignes d'interconnexion.

**42.** Processeur selon l'une quelconque des revendications 36 à 41, dans lequel toutes les portes logiques d'un type particulier sont contenues dans des segments aux portes logiques du même type.

**43.** Processeur selon l'une quelconque des revendications 38 à 42, dans lequel la table de segments est une table de segments de $N_S$ x M bits, où $N_S$ est égal au nombre de segments et M est égal à la somme de tout le nombre de bits de large de la matrice associative 1a, de la matrice associative 1b, du registre de valeurs d'entrée et de la liste de réponses positives.

**44.** Processeur selon l'une quelconque des revendications 38 à 43, dans lequel le temps d'établissement, $T_{ETABLISSEMENT}$, de dispositifs synchrones peut être modélisé et dans lequel $T_{ETABLISSEMENT} = N.p + M$,

où N est égal à un nombre entier, M est égal à un nombre entier < P et P est égal à la largeur binaire de la matrice 1b, dans lequel :

l'entrée d'état de la matrice 1a de ce signal est réglée à $S_{SN}$ ;

un marqueur de début est placé à la position extrême-gauche de la matrice 1b ;

la matrice 1b est incrémentée de façon normale et lorsque le marqueur de début atteint la position extrême-droite de la matrice 1b et que le signal est resté constant, l'état $S_{SN}$ est décrémenté à $S_{SN-1}$, et la prochaine fois que la matrice 1b est incrémentée le marqueur de début est ramené à la position extrême-gauche dans la matrice 1b à nouveau et la matrice 1b est alors incrémentée de façon normale ;

l'étape précédente est répétée jusqu'à ce que l'entrée d'état = $S_{SO}$, puis la matrice 1b est incrémentée M autres fois ; et

si le signal est resté constant pendant N.p + M unités de temps, l'entrée d'état dans la matrice 1a est alors réglée sur l'établissement d'état, $S_{ETABLISSEMENT}$.

45. Processeur selon la revendication 44, dans lequel la durée de maintien, $T_{MAINTIEN}$, de dispositifs synchrones peut être modélisée où $T_{MAINTIEN}$ = R.p + Q, et où R est un nombre entier, Q est un nombre entier < P et P est égal à la largeur binaire de la matrice 1b, dans lequel :

quand une horloge effectue une transition, une recherche des entrées d'état est lancée dans la matrice 1a pour voir si un quelconque signal d'entrée se trouve dans l'état $S_{ETABLISSEMENT}$ ;

les états dans $S_{ETABLISSEMENT}$ sont mis à jour sur l'état $S_{HR}$, et un marqueur de début est placé à la position extrême-gauche de la matrice 1b, la matrice 1b est incrémentée de façon normale jusqu'à ce que le marqueur de début soit parvenu à la position extrême-droite dans la matrice 1b et que le signal soit resté constant ;

l'état est décrémenté à $S_{HR-1}$, et la prochaine fois que la matrice 1b est incrémentée, le marqueur de début est ramené à la position extrême-gauche dans la matrice 1b, la matrice 1b est alors incrémentée de façon normale et ceci continue jusqu'à ce que l'état soit égal à $S_{HO}$ ;

quand $S_{HR}$ est égal à $S_{HO}$ la matrice 1b est alors incrémentée Q autres fois ;

si le signal reste constant durant toute la période, l'état du signal est alors mis à jour sur $S_{MAINTIEN}$ et la valeur de sortie du dispositif est déterminée.

46. Processeur selon la revendication 45, dans lequel si la valeur de sortie a changé, elle est propagée à la liste de sortance du dispositif.

47. Processeur selon l'une quelconque des revendications 36 à 46, dans lequel est fourni un mécanisme d'enregistrement de résultats modifiés dans lequel quand un nombre d'essais est effectué sur la paire de portes, le résultat de chaque essai est envoyé à un registre de résultats où au terme de tous les essais, le registre de résultats indiquera que tous les essais ont réussi ou qu'au moins un essai n'a pas réussi.

48. Processeur selon la revendication 47, dans lequel le registre de résultats comprend un additionneur.

49. Processeur selon la revendication 47, dans lequel le registre de résultats est un dispositif à deux états.

50. Processeur selon la revendication 47, dans lequel le registre de résultats comprend une bascule D.

51. Processeur selon l'une quelconque des revendications 49 à 50, dans lequel le registre de résultats reçoit au démarrage une entrée d'amorçage appropriée au lieu du dernier résultat de telle sorte qu'il soit prêt à recevoir le premier résultat réel.

52. Processeur selon l'une quelconque des revendications 47 à 51, dans lequel le mécanisme d'enregistrement de résultats modifiés comprend en outre un circuit de polarité de résultat afin d'inverser un résultat et de garantir qu'un 1 logique est appliqué au registre de résultats si la réponse correcte à un essai était qu'un essai particulier sur une paire de portes devait échouer.

53. Processeur selon l'une quelconque des revendications 47 à 52, dans lequel le mécanisme d'enregistrement de résultats modifiés est doté en outre d'un circuit de combinaison logique afin de déterminer si une paire de portes de sortie de la matrice 1b doivent faire l'objet d'une opération ET ou OU.

54. Processeur selon la revendication 53, dans lequel le circuit de combinaison logique comprend en outre trois portes ET et une commande de circuit de combinaison logique, la commande de circuit logique faisant l'objet d'une opération ET avec chaque sortie de paire de portes de la matrice 1b et la paire de portes faisant l'objet d'une opération ET dans la troisième porte ET, quand la combinaison logique exige une opération ET, la commande de circuit de combinaison logique reçoit une valeur 0 et quand une opération OU est requise la commande de circuit de combinaison logique reçoit un 1 logique.

55. Processeur selon la revendication 54, dans lequel le circuit de combinaison logique comprend en outre une porte OU, chacune des sorties des trois portes ET étant passée à la porte OU.

**56.** Processeur selon la revendication 55, dans lequel la sortie de la porte OU est amenée au circuit de polarité de résultat.

**57.** Processeur selon l'une quelconque des revendications 36 à 56, dans lequel quand tous les segments actifs ont un état > S0, une vérification de tous les états de segments est effectuée jusqu'à ce que l'état de segment le plus bas $S_{min}$ soit trouvé, puis chaque état de segment est décrémenté par $S_{min}$ affin d'avancer la simulation à l'étage d'évaluation suivant.

**58.** Processeur selon la revendication 57, dans lequel la valeur d'état la plus basse est mémorisée dans un registre global bas et chaque fois qu'il y a un changement d'état de porte, si le nouvel état est inférieur à la valeur du registre d'état global bas il remplace la valeur du registre d'état global bas.

**59.** Processeur selon l'une quelconque des revendications 36 à 58, dans lequel est fourni un système de balayage comprenant un décodeur de priorité et un registre à décalage.

**60.** Processeur selon l'une quelconque des revendications 47 à 59, dans lequel est fourni un mécanisme d'enregistrement de résultats modifiés pour chaque paire de portes.

**61.** Processeur selon l'une quelconque des revendications 36 à 60, dans lequel est fournie une table d'adresses de segments et la table d'adresses de segments est divisée en un nombre de rangées, chaque rangée étant de M bits de long, et chaque adresse de segment est mémorisée dans les M-D bits de poids fort de la rangée de segment quand le nombre de segments = $2^D$.

**62.** Processeur selon l'une quelconque des revendications 36 à 61, dans lequel le processeur est mis en oeuvre dans un format lisible par ordinateur.

**63.** Processeur selon la revendication 62, dans lequel le processeur au format lisible par ordinateur est mémorisé sur un disque.

**64.** Processeur selon la revendication 62, dans lequel le processeur au format lisible par ordinateur est mémorisé sur un support d'enregistrement.

Fig. 1

5   7   6   9   14

i$^m$
Entry

S. 1

n. Entries

<u>Fig. 2</u>

30

32

31

<u>Fig. 3</u>

41   42   40

SEGMENT

<u>Fig. 4</u>

Fig. 5

Fig. 6

Fig. 7

$T_{SETUP}$  $T_{HOLD}$

Inputs of Gate A

Clock

Output of Gate A

Fig. 8

5                                    7

GATE TYPE                         } GATE INPUT PAIR

11 — Mask Register 1a

12 — Input Register 1a

Fig. 9

Fig. 10

**EP 1 476 828 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 0101298 A